# EUROPEAN PATENT APPLICATION

(11) **EP 4 826 452 A1**
(43) Date of publication of application: **21.10.2026**
(21) Application number: 24903782.1
(22) Date of filing: 13.12.2024
(51) Int. Cl.: G03F 7/11, C08G 59/40, G03F 7/20

(54) **COMPOSITION FOR FORMING RESIST UNDERLAYER FILM, AND RESIST UNDERLAYER FILM**

(30) Priority: 15.12.2023 JP 2023212068
(71) Applicant: Nissan Chemical Corporation, Tokyo 103-6119 (JP)
(72) Inventor: SHIMIZU, Shou, Toyama-shi, Toyama 939-2792 (JP); TAMURA, Mamoru, Toyama-shi, Toyama 939-2792 (JP)
(74) Representative: Hoffmann Eitle
(86) International application number: PCT/JP2024/044166
(87) International publication number: WO 2025/127129

(57) **Abstract**

Provided are a resist underlayer film-forming composition and resist underlayer film that can be improved in sensitivity in EB lithography or EUV lithography, as compared with conventional ones; a resist underlayer film-forming composition for forming a resist underlayer film, containing a polymer (A) and a solvent (B), wherein the resist underlayer film has a contact angle with pure water of 80° or more; and a resist underlayer film-forming composition wherein the polymer (A) is a polymer containing fluorine atoms.

## Description

### Technical Field

The present invention relates to a resist underlayer film-forming composition and a resist underlayer film.

### Background Art

In semiconductor devices such as large scale integrated (LSI) circuits, as integration degree increases, the formation of fine patterns is required. The minimum pattern size in recent years has reached 100 nm or less.

The formation of fine patterns in semiconductor devices has been realized by using shorter wavelength light sources in exposure devices and improvement of resist materials. At present, immersion lithography is performed, which is a method of applying light through water using a deep ultraviolet light, such as argon fluoride (ArF) excimer laser light of 193 nm in wavelength, as a light source. As for the resist materials, various ArF compatible resist materials using an acrylic resin as a base have been developed.

Furthermore, a next-generation lithography technology, such as electron beam (EB) lithography using an electron beam or extreme ultraviolet (EUV) lithography using a soft X ray of 13.5 nm in wavelength as a light source, is under study and a further reduction of pattern size is progressing to a level of 30 nm or less.

However, with the reduction of pattern size, line edge roughness (LER) of a resist pattern side-wall, and line width roughness (LWR) of the resist pattern become serious. There is growing concern that the device performance may be affected. Studies have been made to suppress these, for example, by optimizing exposure devices, resist materials, and process conditions, but sufficient results have not been obtained. Note that LWR and LER are linked, that is, improving LWR also improves LER.

For solving the above problems, an invention of a resist underlayer film is disclosed, which is, a baked product of a coating film of a resist underlayer film-forming composition containing a polymer which has at least one of a unit structure having a polycyclic aromatic hydrocarbon structure and a unit structure having a maleimide structure (see, Patent Literature 1).

### Citation List

### Patent Literature

Patent Literature 1: WO 2023/106364 A

### Summary of Invention

### Technical Problem

In pattern formation by EB lithography or EUV lithography, there is a demand for improving LWR and LER, as described above, and for increasing sensitivity such that patterns can be formed even when exposure energy is low.

The present invention provides a resist underlayer film-forming composition and resist underlayer film that can be improved in sensitivity in EB lithography or EUV lithography as compared with conventional ones.

### Solution to Problem

The present inventors conducted intensive studies to solve the above problems. As a result, they have found that the above problem can be overcome, and have accomplished the present invention summarized below.

That is, the present invention includes the following items.
[1] A resist underlayer film-forming composition for forming a resist underlayer film, including:
   a polymer (A) and a solvent (B), wherein
   the resist underlayer film has a contact angle with water of 80° or more.
[2] The resist underlayer film-forming composition according to [1], wherein the polymer (A) is a polymer containing fluorine atoms.
[3] The resist underlayer film-forming composition according to [1] or [2], wherein the polymer (A) is a polymer containing 10 mol% or more of the fluorine atoms.
[4] A resist underlayer film-forming composition including a polymer (A) and a solvent (B), wherein the polymer (A) is a polymer containing 10 mol% or more of fluorine atoms.
[5] The resist underlayer film-forming composition according to any one of [1] to [4], wherein the polymer (A) is a polymer having a structural unit represented by the following formula (1): 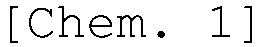 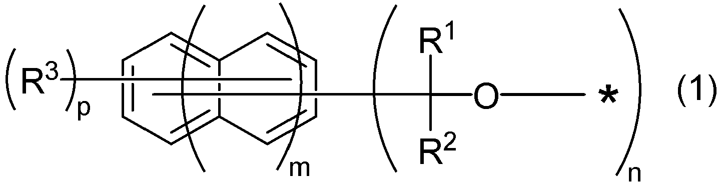 in the formula (1), R¹ and R² each independently represent a perfluoroalkyl group having 1 to 6 carbon atoms or a perfluoroalkyl group having 1 to 6 carbon atoms in which 1 to 12 fluorine atoms are substituted with one or both of hydrogen atoms and halogen atoms; R³s each independently represent an alkyl group having 1 to 3 carbon atoms, which may be substituted, or a halogen atom; m represents 0 or 1; n represents 2 or 3; p represents 0 to 6, with the proviso that, if m = 0, p + n is 6 or less, and if m = 1, p + n is 8 or less; and * represents a bonding arm.
[6] The resist underlayer film-forming composition according to any one of [2] to [5], wherein the polymer (A) is a reaction product of a compound having two or more epoxy groups and a fluorine-containing compound having two or more groups reactive with the epoxy groups.
[7] The resist underlayer film-forming composition according to any one of [1] to [6], wherein the solvent (B) contains at least one selected from the group consisting of alkylene glycol monoalkyl ethers and monocarboxylic acid esters of alkylene glycol monoalkyl ethers.
[8] The resist underlayer film-forming composition according to any one of [1] to [7], further including a crosslinking agent (C).
[9] The resist underlayer film-forming composition according to [8], wherein the crosslinking agent (C) is at least one selected from the group consisting of aminoplast crosslinking agents and phenoplast crosslinking agents.
[10] The resist underlayer film-forming composition according to any one of [1] to [9], further including a curing catalyst (D).
[11] The resist underlayer film-forming composition according to any one of [1] to [10], which is used in an extreme ultraviolet (EUV) lithography process.
[12] A resist underlayer film, which is a cured product of the resist underlayer film-forming composition according to any one of [1] to [11].
[13] A laminate, including:
   a semiconductor substrate, and
   the resist underlayer film according to [12].
[14] A method for producing a semiconductor element including steps of:
   forming a resist underlayer film on a semiconductor substrate using the resist underlayer film-forming composition according to any one of [1] to [11]; and
   forming a resist film on the resist underlayer film.
[15] A method for forming a pattern, including steps of:
   forming a resist underlayer film on a semiconductor substrate using the resist underlayer film-forming composition according to any one of [1] to [11];
   forming a resist film on the resist underlayer film;
   irradiating the resist film with light or an electron beam, and then developing the resist film to obtain a resist pattern; and
   etching the resist underlayer film with the resist pattern used as a mask.

### Advantageous Effects of Invention

According to the present invention, it is possible to provide a resist underlayer film-forming composition and resist underlayer film that can be improved in sensitivity in EB lithography or EUV lithography as compared with conventional ones.

### Description of Embodiments

### (Resist Underlayer Film-forming Composition)

An example of the resist underlayer film-forming composition of the present invention contains a polymer (A) and a solvent (B), wherein
the resist underlayer film has a contact angle with pure water of 80° or more.

Another example of the resist underlayer film-forming composition of the present invention contains a polymer (A) and a solvent (B), and
the polymer (A) contains 10 mol% or more of fluorine atoms.

The present inventors have conducted intensive studies, with a view to overcoming the above problems, on a resist underlayer film-forming composition such that patterns can be formed even when exposure energy is low. As a result, they found that when a resist underlayer film is formed, the contact angle with water is usually about 40° to 60°, but if a resist underlayer film-forming composition exhibiting strong water repellency is used, formation of a highly sensitive pattern can be realized. Based on the finding, the present invention was conceived.

Note that the contact angle with water can be measured by a fully automatic contact angle meter (DM-701, manufactured by Kyowa Interface Science Co., Ltd.). After 3.0 µl of water is added, water is allowed to stand for 3 seconds, and then measured. Measurement is performed at 5 points after 5 seconds, and at 5 points after 7 seconds. The contact angle can be obtained through calculation as an average of the values at, in total, 15 measurement points. The water to be used for measuring the contact angle is preferably pure water.

### <Polymer (A)>

The polymer (A) is preferably a polymer containing fluorine atoms. As long as the effect of the present invention is not impaired, the type of organic group to be formed of the fluorine atoms contained in the polymer (A) is not particularly limited, and the amount of the fluorine atoms to be contained in the polymer (A) is not limited.

The polymer (A) is preferably a polymer containing 10 mol% or more of fluorine atoms relative to the whole atoms of the polymer. The polymer (A) preferably contains 11 mol% or more of fluorine atoms, and particularly preferably 12 mol% or more of fluorine atoms. When the polymer (A) contains a predetermined amount or more of fluorine atoms, the exposure amount required in EB lithography or EUV lithography is reduced, and the sensitivity is likely to be improved.

The upper limit value of the amount of fluorine atoms to be contained in the polymer (A) is not limited, but is preferably 20 mol% or less from the viewpoint of film formability.

The polymer (A) is preferably a polymer having a structural unit represented by the following formula (1): 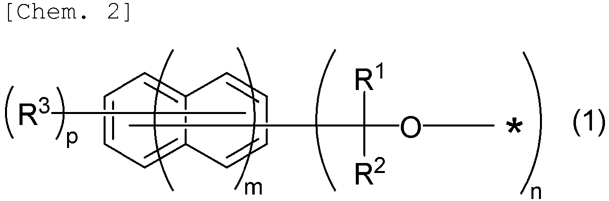 in the formula (1), R¹ and R² each independently represent a perfluoroalkyl group having 1 to 6 carbon atoms or a perfluoroalkyl group having 1 to 6 carbon atoms in which 1 to 12 fluorine atoms are substituted with one or both of hydrogen atoms and halogen atoms; R³s each independently represent an alkyl group having 1 to 3 carbon atoms, which may be substituted, or a halogen atom; m represents 0 or 1; n represents 2 or 3; p represents 0 to 6, with the proviso that, if m = 0, p + n is 6 or less, and if m = 1, p + n is 8 or less; and * represents a bonding arm.

The perfluoroalkyl group having 1 to 6 carbon atoms may be linear, branched, or cyclic, and is preferably linear. Examples of the perfluoroalkyl group having 1 to 6 carbon atoms include a trifluoromethyl group, a pentafluoroethyl group, a heptafluoropropyl group, a 2,2,2-trifluoro-1-(trifluoromethyl)ethyl group, a nonafluorobutyl group, an undecafluoropentyl group, and a tridecafluorohexyl group. In consideration of the effect of reducing the exposure amount in pattern formation, a trifluoromethyl group is favorable.

In the perfluoroalkyl group having 1 to 6 carbon atoms, 1 to 12 fluorine atoms may be substituted with one or both of hydrogen atoms and halogen atoms. Examples of the halogen atoms include fluorine atoms, chlorine atoms, bromine atoms, and iodine atoms.

Examples of the alkyl group having 1 to 3 carbon atoms include a methyl group, an ethyl group, an n-propyl group, an i-propyl group, and a cyclopropyl group. Of these, a methyl group is preferred.

Reference symbol p is an integer of 0 to 6, preferably an integer of 0 to 3, and particularly preferably 0 or 1.

Examples of the structural unit represented by formula (1) include the following structural units: 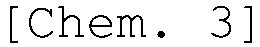 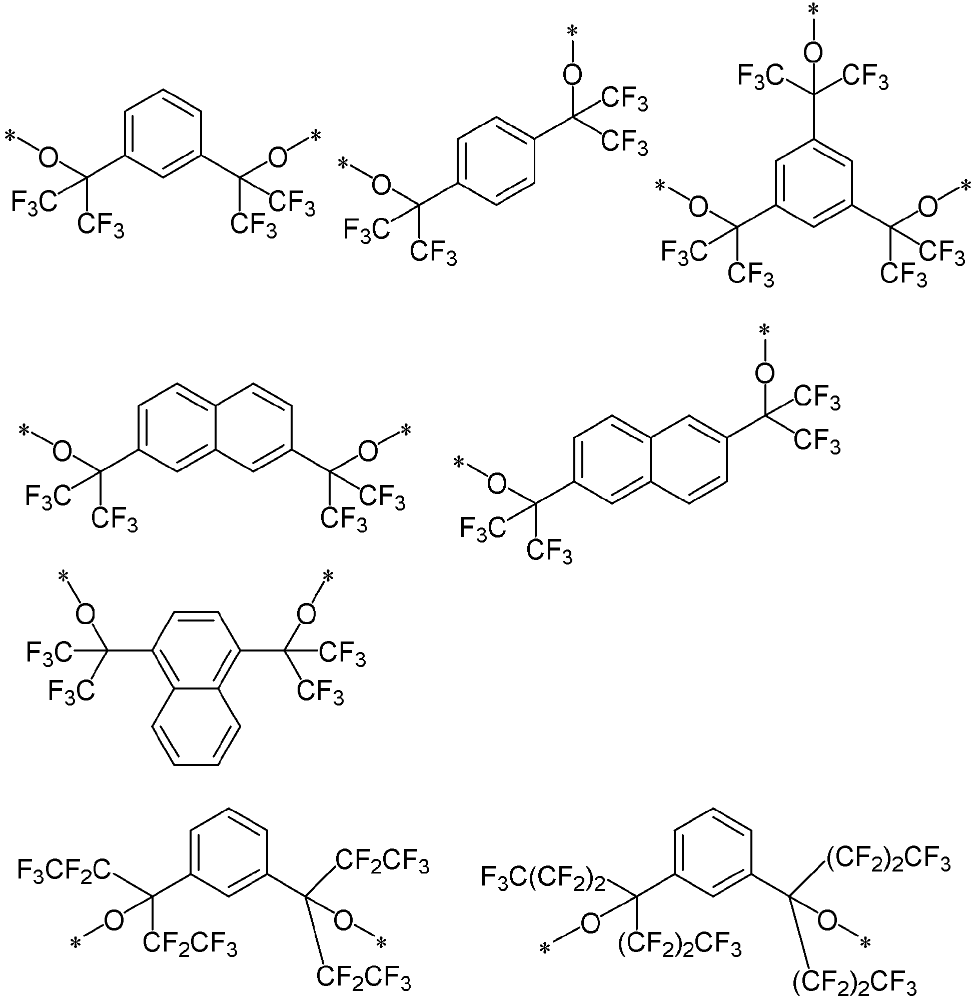 wherein * represents a bonding arm.

The ratio of the structural units represented by the formula (1) in the polymer (A) is not particularly limited, but the ratio (mass%) of the structural units represented by the formula (1) relative to the total mass of the polymer (A) may be, for example, 5 mol% to 60 mol%, 10 mol% to 40 mol%, or is preferably 30 mol% or more and 40 mol% or less. The polymer (A) may have a structure other than the structural unit represented by formula (1).

### <<Compound Having Two or More Epoxy Groups>>

Examples of the polymer (A) containing the structural unit represented by the formula (1) include a reaction product of a compound having two or more epoxy groups and a fluorine-containing compound having two or more groups reactive with the epoxy groups.

Examples of the compound having two or more epoxy groups include, but are not particularly limited to, a diepoxy compound, a triepoxy compound, a tetraepoxy compound, and a polymer having epoxy groups. The compound having two or more epoxy groups is preferably a diepoxy compound or a triepoxy compound, and more preferably a diepoxy compound.

Examples of the compound having two or more epoxy groups include compounds represented by the following structures.

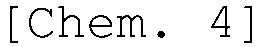

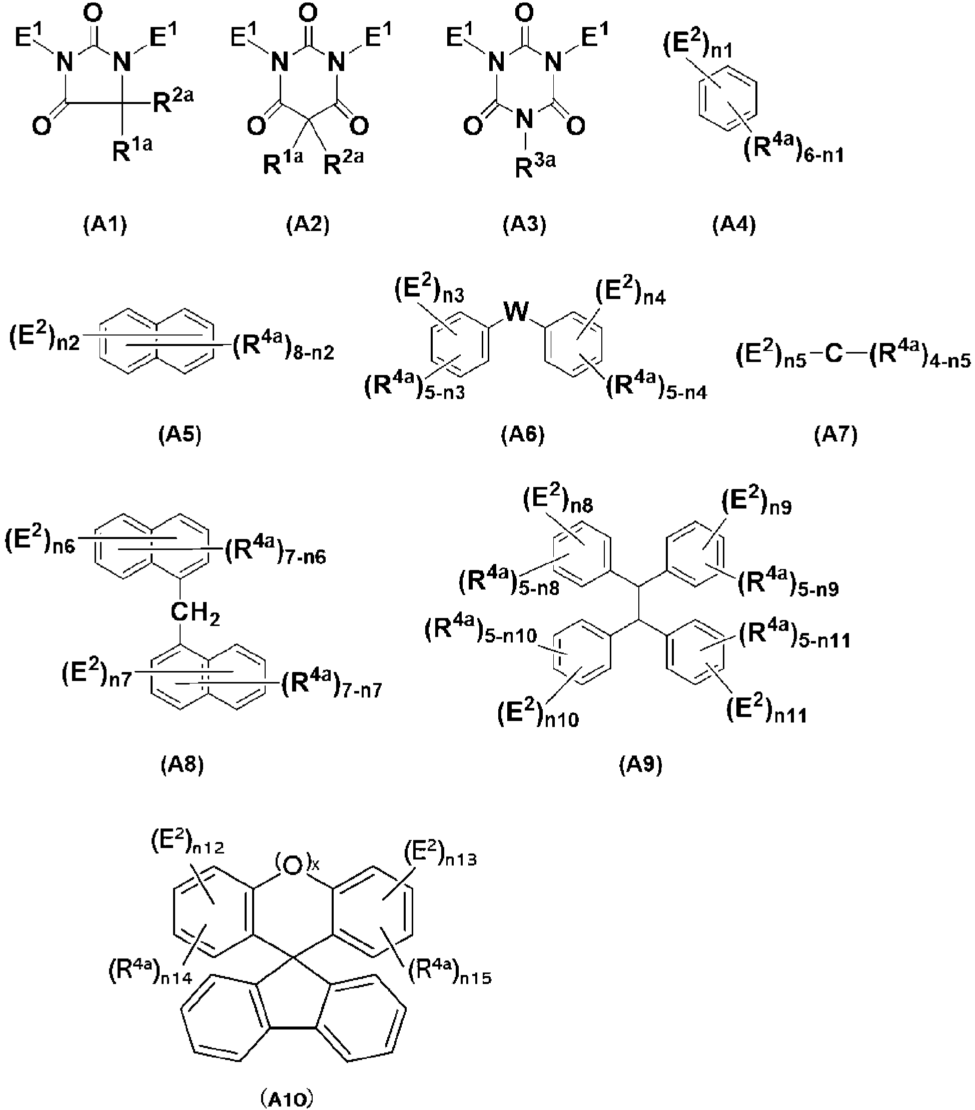

In the formulas (A1) to (A3), E¹ is a group represented by the following formula (a-1). 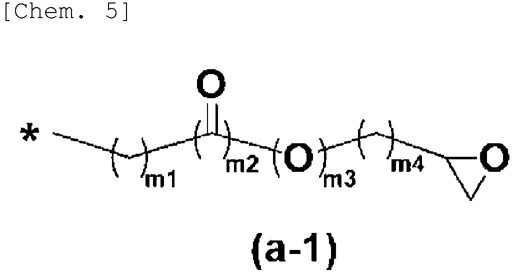 wherein m1 is an integer of 0 to 4; m2 is 0 or 1; m3 is 0 or 1; m4 is 1 or 2, with the proviso that if m3 is 1, m1 and m2 are not 0 at the same time; and * represents a bonding arm.

In the formulas (A4) to (A10), E² is a group represented by the following formula (a-2). 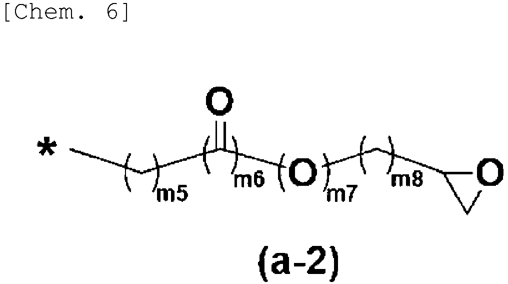 wherein m5 is an integer of 0 to 4; m6 is 0 or 1; m7 is 0 or 1; and m8 is 1 or 2; and * represents a bonding arm.

In formulas (A1) and (A2), R^{1a} and R^{2a} each independently represent a hydrogen atom, an alkyl group having 1 to 10 carbon atoms, which may be interrupted by an oxygen atom or a sulfur atom, an alkenyl group having 2 to 10 carbon atoms, which may be interrupted by an oxygen atom or a sulfur atom, an alkynyl group having 2 to 10 carbon atoms, which may be interrupted by an oxygen atom or a sulfur atom, a benzyl group, or a phenyl group, in which the phenyl group may be substituted with at least one monovalent group selected from the group consisting of an alkyl group having 1 to 6 carbon atoms, a halogen atom, an alkoxy group having 1 to 6 carbon atoms, a nitro group, a cyano group, and an alkylthio group having 1 to 6 carbon atoms.

In the formula (A3), R^{3a} represents a hydrogen atom; an alkyl group having 1 to 10 carbon atoms, which may be interrupted by an oxygen atom or a sulfur atom; an alkenyl group having 2 to 10 carbon atoms, which may be interrupted by an oxygen atom or a sulfur atom; an alkynyl group having 2 to 10 carbon atoms, which may be interrupted by an oxygen atom or a sulfur atom; a benzyl group, a phenyl group, or the E¹ mentioned above, in which the phenyl group may be substituted with at least one monovalent group selected from an alkyl group having 1 to 10 carbon atoms, a halogen atom, an alkoxy group having 1 to 6 carbon atoms, a nitro group, a cyano group, and an alkylthio group having 1 to 6 carbon atoms.

Examples of the alkyl group having 1 to 10 carbon atoms include a methyl group, an ethyl group, an n-propyl group, an i-propyl group, a cyclopropyl group, an n-butyl group, an i-butyl group, an s-butyl group, a t-butyl group, a cyclobutyl group, a 1-methyl-cyclopropyl group, a 2-methyl-cyclopropyl group, an n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl group, a 1-ethyl-cyclopropyl group, a 2-ethyl-cyclopropyl group, an n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, a 1-ethyl-2-methyl-n-propyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl-cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, and a 2-ethyl-3-methyl-cyclopropyl group.

Examples of the alkenyl group having 2 to 10 carbon atoms include an ethenyl group, a 1-propenyl group, a 2-propenyl group, a 1-methyl-1-ethenyl group, a 1-butenyl group, a 2-butenyl group, a 3-butenyl group, a 2-methyl-1-propenyl group, a 2-methyl-2-propenyl group, a 1-ethylethenyl group, a 1-methyl-1-propenyl group, a 1-methyl-2-propenyl group, a 1-pentenyl group, a 2-pentenyl group, a 3-pentenyl group, a 4-pentenyl group, a 1-n-propylethenyl group, a 1-methyl-1-butenyl group, a 1-methyl-2-butenyl group, a 1-methyl-3-butenyl group, a 2-ethyl-2-propenyl group, a 2-methyl-1-butenyl group, a 2-methyl-2-butenyl group, a 2-methyl-3-butenyl group, a 3-methyl-1-butenyl group, a 3-methyl-2-butenyl group, a 3-methyl-3-butenyl group, a 1,1-dimethyl-2-propenyl group, 1-i-propylethenyl group, a 1,2-dimethyl-1-propenyl group, a 1,2-dimethyl-2-propenyl group, a 1-cyclopentenyl group, a 2-cyclopentenyl group, a 3-cyclopentenyl group, a 1-hexenyl group, a 2-hexenyl group, a 3-hexenyl group, a 4-hexenyl group, a 5-hexenyl group, a 1-methyl-1-pentenyl group, a 1-methyl-2-pentenyl group, a 1-methyl-3-pentenyl group, a 1-methyl-4-pentenyl group, a 1-n-butylethenyl group, a 2-methyl-1-pentenyl group, a 2-methyl-2-pentenyl group, a 2-methyl-3-pentenyl group, a 2-methyl-4-pentenyl group, a 2-n-propyl-2-propenyl group, a 3-methyl-1-pentenyl group, a 3-methyl-2-pentenyl group, a 3-methyl-3-pentenyl group, a 3-methyl-4-pentenyl group, a 3-ethyl-3-butenyl group, a 4-methyl-1-pentenyl group, a 4-methyl-2-pentenyl group, a 4-methyl-3-pentenyl group, a 4-methyl-4-pentenyl group, a 1,1-dimethyl-2-butenyl group, a 1,1-dimethyl-3-butenyl group, a 1,2-dimethyl-1-butenyl group, a 1,2-dimethyl-2-butenyl group, a 1,2-dimethyl-3-butenyl group, a 1-methyl-2-ethyl-2-propenyl group, a 1-s-butylethenyl group, a 1,3-dimethyl-1-butenyl group, a 1,3-dimethyl-2-butenyl group, a 1,3-dimethyl-3-butenyl group, a 1-i-butylethenyl group, a 2,2-dimethyl-3-butenyl group, a 2,3-dimethyl-1-butenyl group, a 2,3-dimethyl-2-butenyl group, a 2,3-dimethyl-3-butenyl group, a 2-i-propyl-2-propenyl group, a 3,3-dimethyl-1-butenyl group, a 1-ethyl-1-butenyl group, a 1-ethyl-2-butenyl group, a 1-ethyl-3-butenyl group, a 1-n-propyl-1-propenyl group, a 1-n-propyl-2-propenyl group, a 2-ethyl-1-butenyl group, a 2-ethyl-2-butenyl group, a 2-ethyl-3-butenyl group, a 1,1,2-trimethyl-2-propenyl group, a 1-t-butylethenyl group, a 1-methyl-1-ethyl-2-propenyl group, a 1-ethyl-2-methyl-1-propenyl group, a 1-ethyl-2-methyl-2-propenyl group, a 1-i-propyl-1-propenyl group, a 1-i-propyl-2-propenyl group, a 1-methyl-2-cyclopentenyl group, a 1-methyl-3-cyclopentenyl group, a 2-methyl-1-cyclopentenyl group, a 2-methyl-2-cyclopentenyl group, a 2-methyl-3-cyclopentenyl group, a 2-methyl-4-cyclopentenyl group, a 2-methyl-5-cyclopentenyl group, a 2-methylene-cyclopentyl group, a 3-methyl-1-cyclopentenyl group, a 3-methyl-2-cyclopentenyl group, a 3-methyl-3-cyclopentenyl group, a 3-methyl-4-cyclopentenyl group, a 3-methyl-5-cyclopentenyl group, a 3-methylene-cyclopentyl group, a 1-cyclohexenyl group, a 2-cyclohexenyl group, and a 3-cyclohexenyl group.

Examples of the alkynyl group having 2 to 10 carbon atoms include an ethynyl group, a 1-propynyl group, a 2-propynyl group, a 1-butynyl group, a 2-butynyl group, a 3-butynyl group, a 4-methyl-1 pentynyl group, and a 3-methyl-1-pentynyl group.

The "which may be interrupted by an oxygen atom or a sulfur atom" means that, for example, a carbon atom in the middle of a saturated carbon chain of the alkyl group, alkenyl group, and alkynyl group mentioned above is substituted with an oxygen atom or a sulfur atom. For example, in the alkyl group, alkenyl group, and alkynyl group, if an arbitrary carbon atom is substituted with an oxygen atom, an ether bond is contained, whereas if an arbitrary carbon atom is substituted with a sulfur atom, a thioether bond is contained.

Examples of the halogen atoms include fluorine atoms, chlorine atoms, bromine atoms, and iodine atoms.

Examples of the alkoxy group having 1 to 6 carbon atoms include a methoxy group, an ethoxy group, an n-propoxy group, an i-propoxy group, an n-butoxy group, an i-butoxy group, an s-butoxy group, a t-butoxy group, an n-pentoxy group, a 1-methyl-n-butoxy group, a 2-methyl-n-butoxy group, a 3-methyl-n-butoxy group, a 1,1-dimethyl-n-propoxy group, a 1,2-dimethyl-n-propoxy group, a 2,2-dimethyl-n-propoxy group, a 1-ethyl-n-propoxy group, an n-hexyloxy group, a 1-methyl-n-pentyloxy group, a 2-methyl-n-pentyloxy group, a 3-methyl-n-pentyloxy group, a 4-methyl-n-pentyloxy group, a 1,1-dimethyl-n-butoxy group, a 1,2-dimethyl-n-butoxy group, a 1,3-dimethyl-n-butoxy group, a 2,2-dimethyl-n-butoxy group, a 2,3-dimethyl-n-butoxy group, a 3,3-dimethyl-n-butoxy group, a 1-ethyl-n-butoxy group, a 2-ethyl-n-butoxy group, a 1,1,2-trimethyl-n-propoxy group, a 1,2,2-trimethyl-n-propoxy group, a 1-ethyl-1-methyl-n-propoxy group, and a 1-ethyl-2-methyl-n-propoxy group.

Examples of the alkylthio group having 1 to 6 carbon atoms include an ethylthio group, a butylthio group, and a hexylthio group.

In the formulas (A4) to (A10), R^{4a}s each independently represent a hydrogen atom, an alkyl group having 1 to 10 carbon atoms or an alkenyl group having 2 to 10 carbon atoms, wherein -W- represents a single bond, -CH₂-, - C(CH₃)₂-, -C(CF₃)₂-, -CO-, -O-, -OCH₂-CH(OH)-CH₂O-, -S-, or SO₂-; n1 represents an integer of 2 to 4; X represents 0 or 1, with the proviso that if X = 1, an oxygen atom forms a cross-linked structure between aromatic rings as an ether bond, and if X = 0, there is no ether bond that forms a cross-linked structure between aromatic rings; n2 represents an integer of 2 to 4; n3 and n4 each independently represent an integer of 0 to 4, and n3 + n4 is 2 to 4; n5 represents an integer of 2 to 4; n6 and n7 each independently represent an integer of 0 to 4, and n6 + n7 is 2 to 4; n8 to n11 each independently represent an integer of 0 to 4, and n8 + n9 + n10 + n11 is 2 to 4; n12 and n13 each independently represent an integer of 0 to 5, and n12 + n13 is 2 to 4; n14 is 5-n12 if X is 0, and is 4-n12 if X is 1; and n15 is 5-n13 if X is 0, and is 4-n13 if X is 1.

Examples of the alkyl group having 1 to 10 carbon atoms and the alkenyl group having 2 to 10 carbon atoms include the same groups as those mentioned above.

In the present invention, of these epoxy compounds, the epoxy compounds represented by the formulas (A3), (A6) and (A10) are preferable from the viewpoint of reactivity with the polymer (A), and in particular, those having the aspects shown below can be more favorably used.

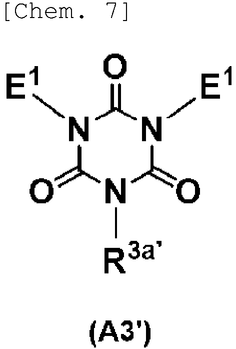

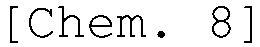

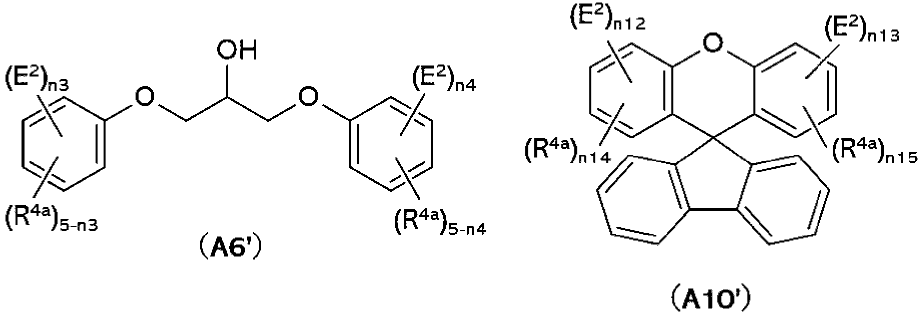

In the formulas, E¹, E², R^{4a}, n3, n4, and n12 to n15 are the same as defined above, and R^{3a'} is a hydrogen atom, an alkyl group having 1 to 10 carbon atoms, which may be interrupted by an oxygen atom or a sulfur atom, an alkenyl group having 2 to 10 carbon atoms, which may be interrupted by an oxygen atom or a sulfur atom, an alkynyl group having 2 to 10 carbon atoms, which may be interrupted by an oxygen atom or a sulfur atom, a benzyl group, or a phenyl group, in which the phenyl group may be substituted with at least one monovalent group selected from an alkyl group having 1 to 6 carbon atoms, a halogen atom, an alkoxy group having 1 to 6 carbon atoms, a nitro group, a cyano group, and an alkylthio group having 1 to 6 carbon atoms.

Examples of the epoxy compounds represented by the above formulas (A1) to (A10) include, but are not limited to, the following compounds.

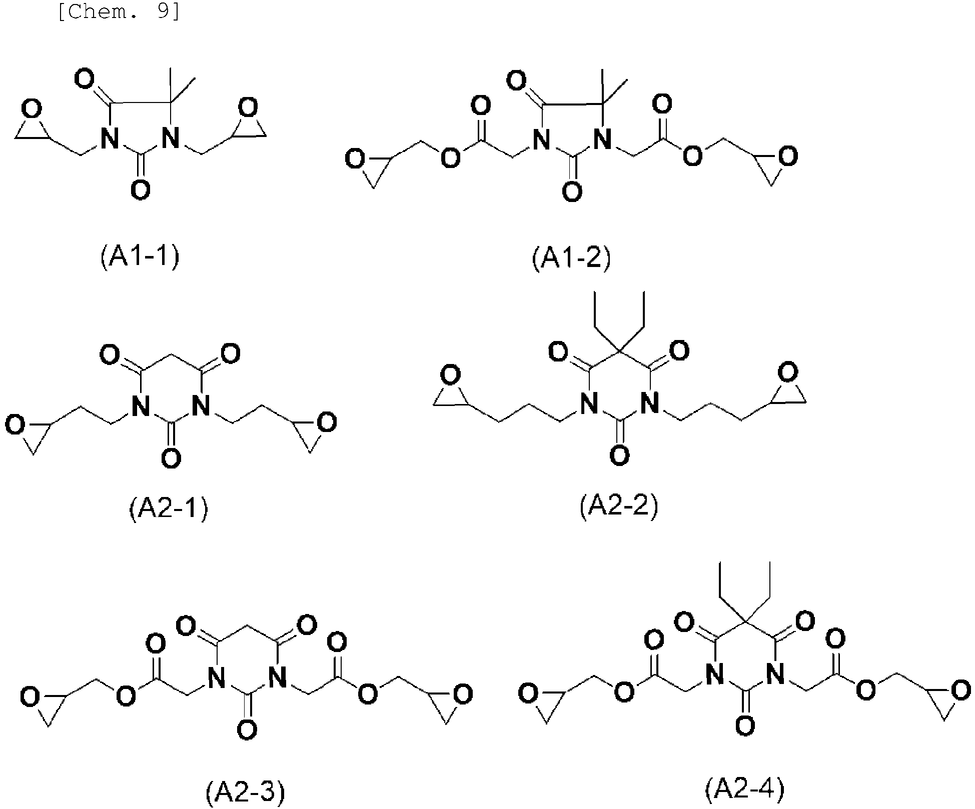

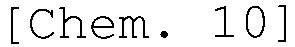

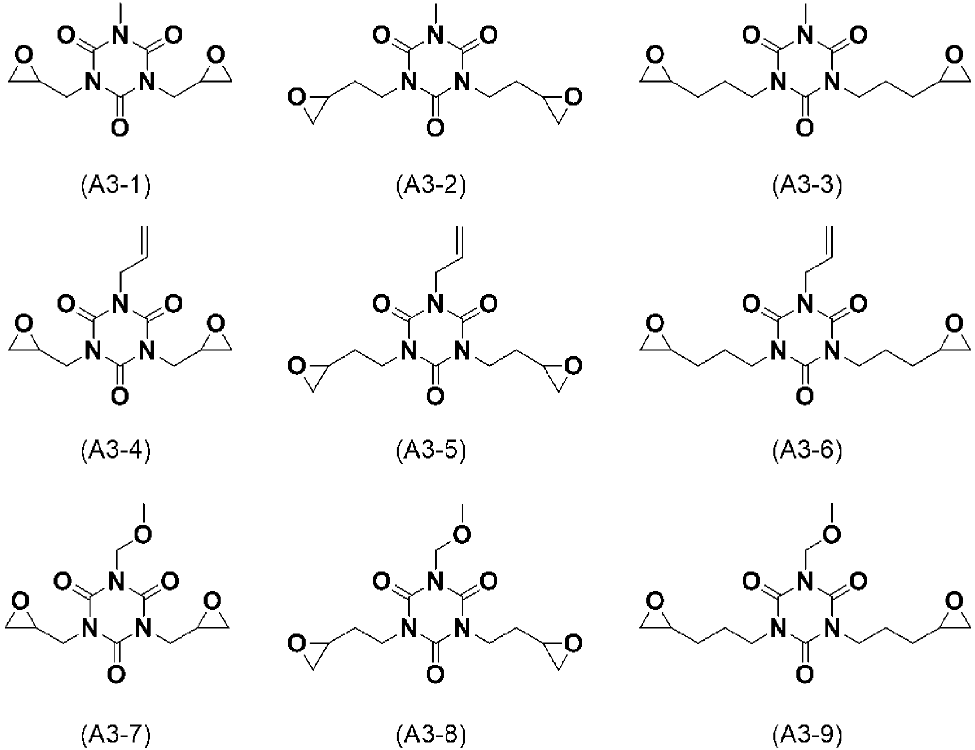

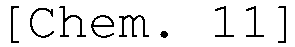

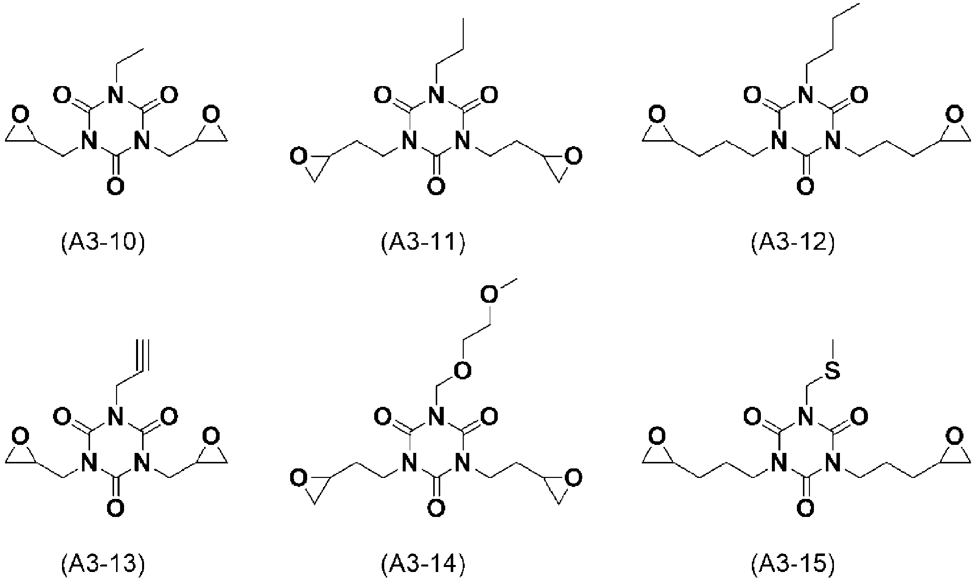

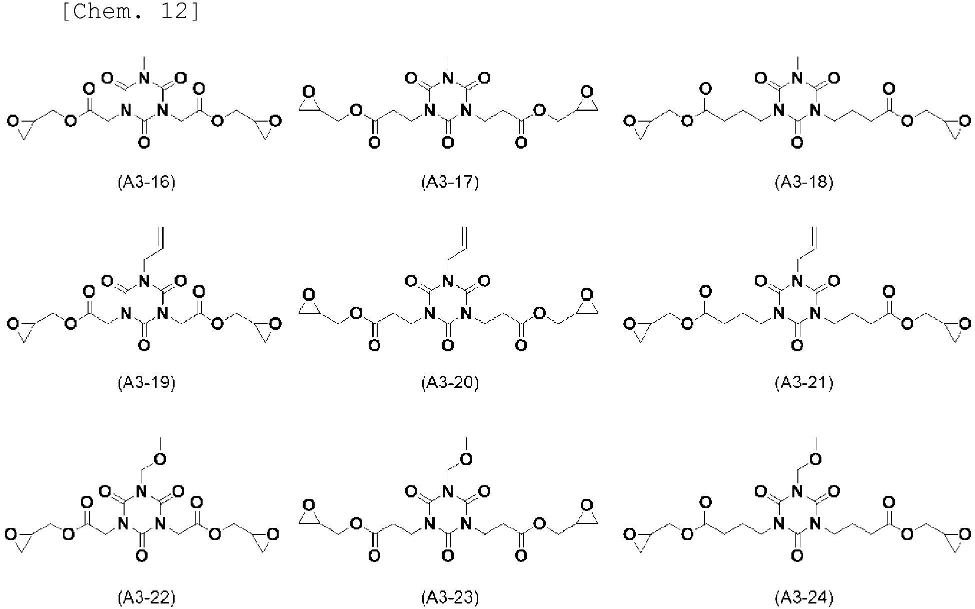

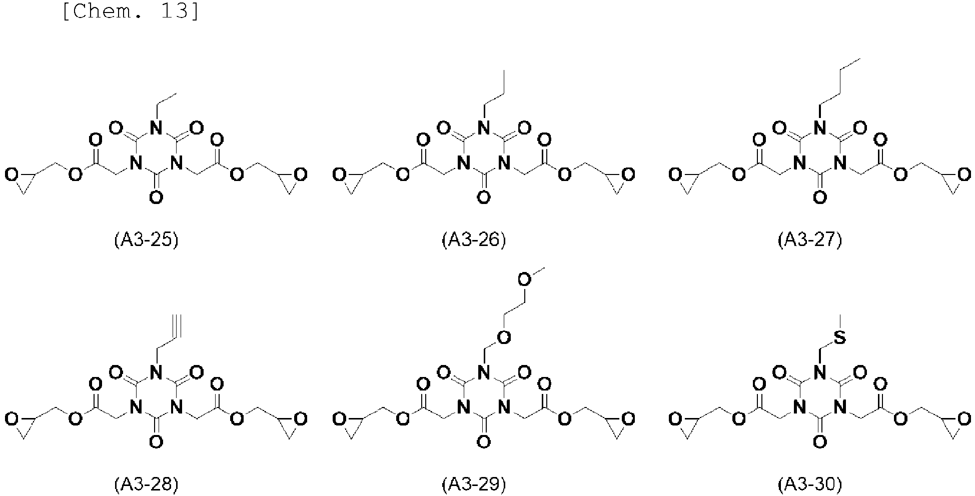

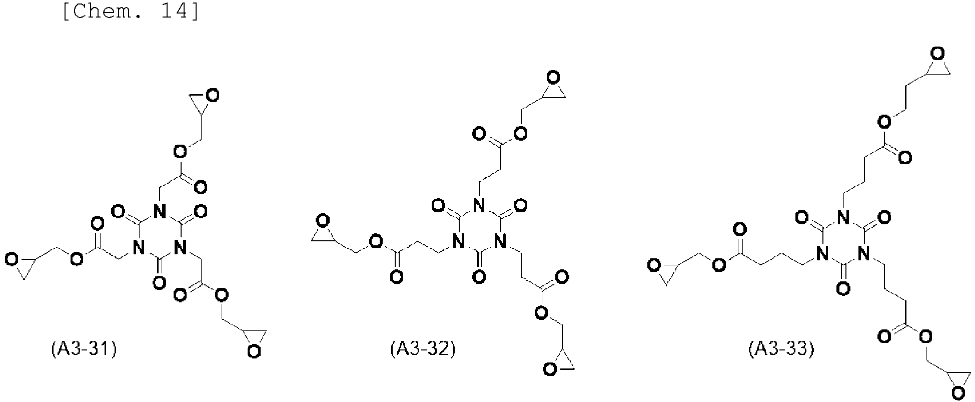

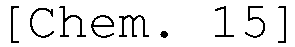

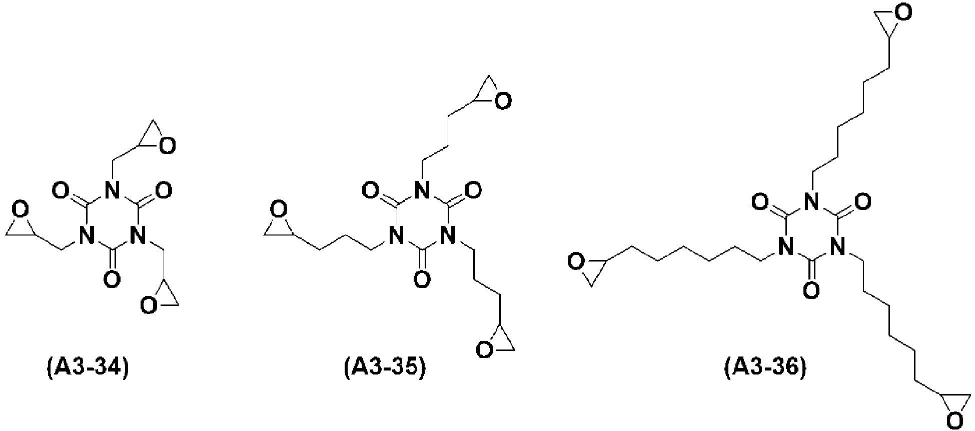

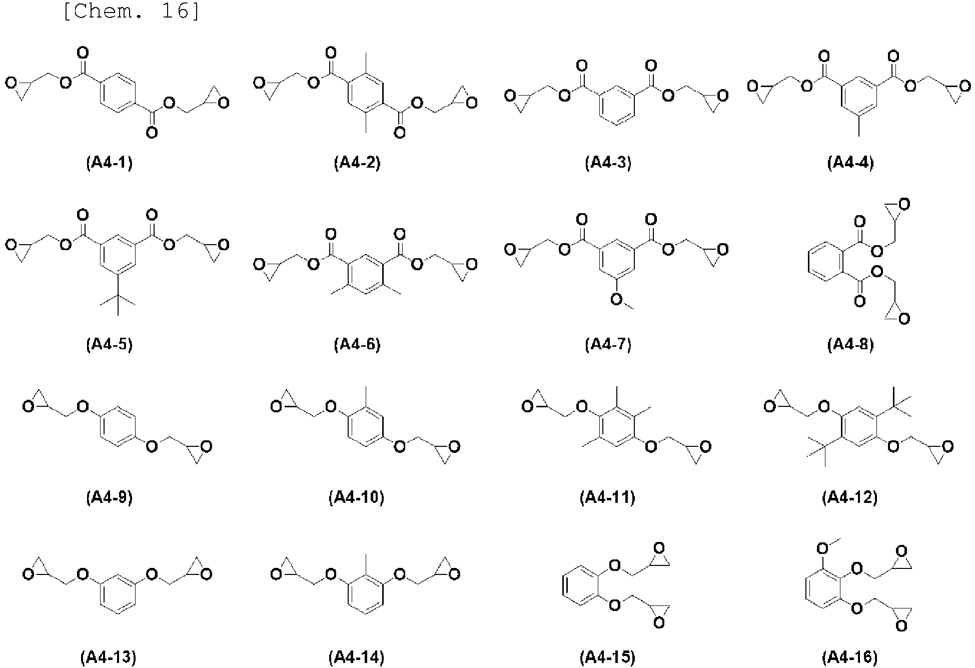

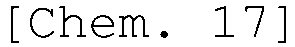

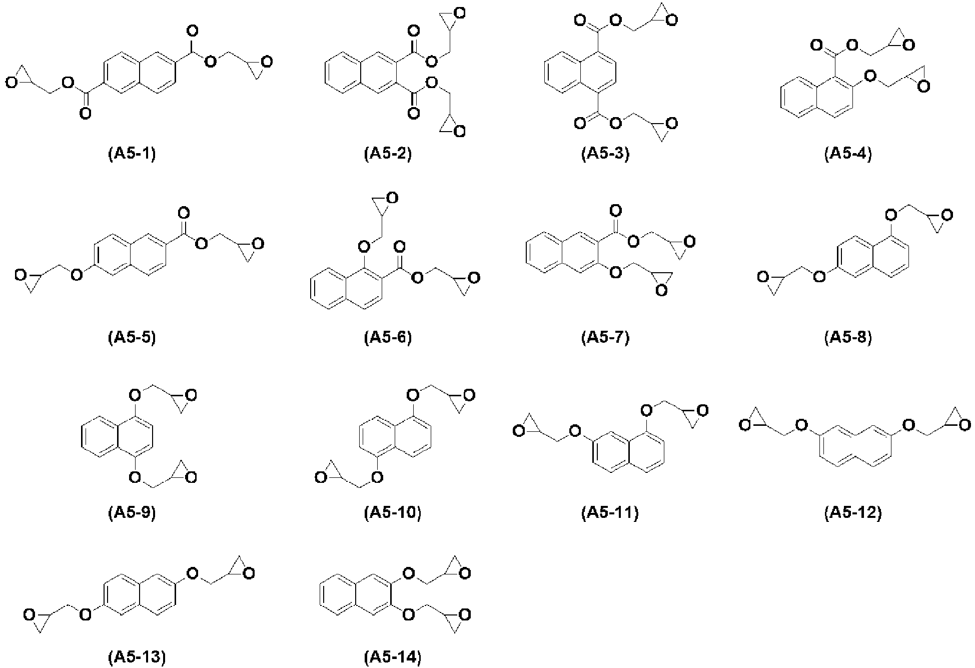

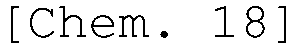

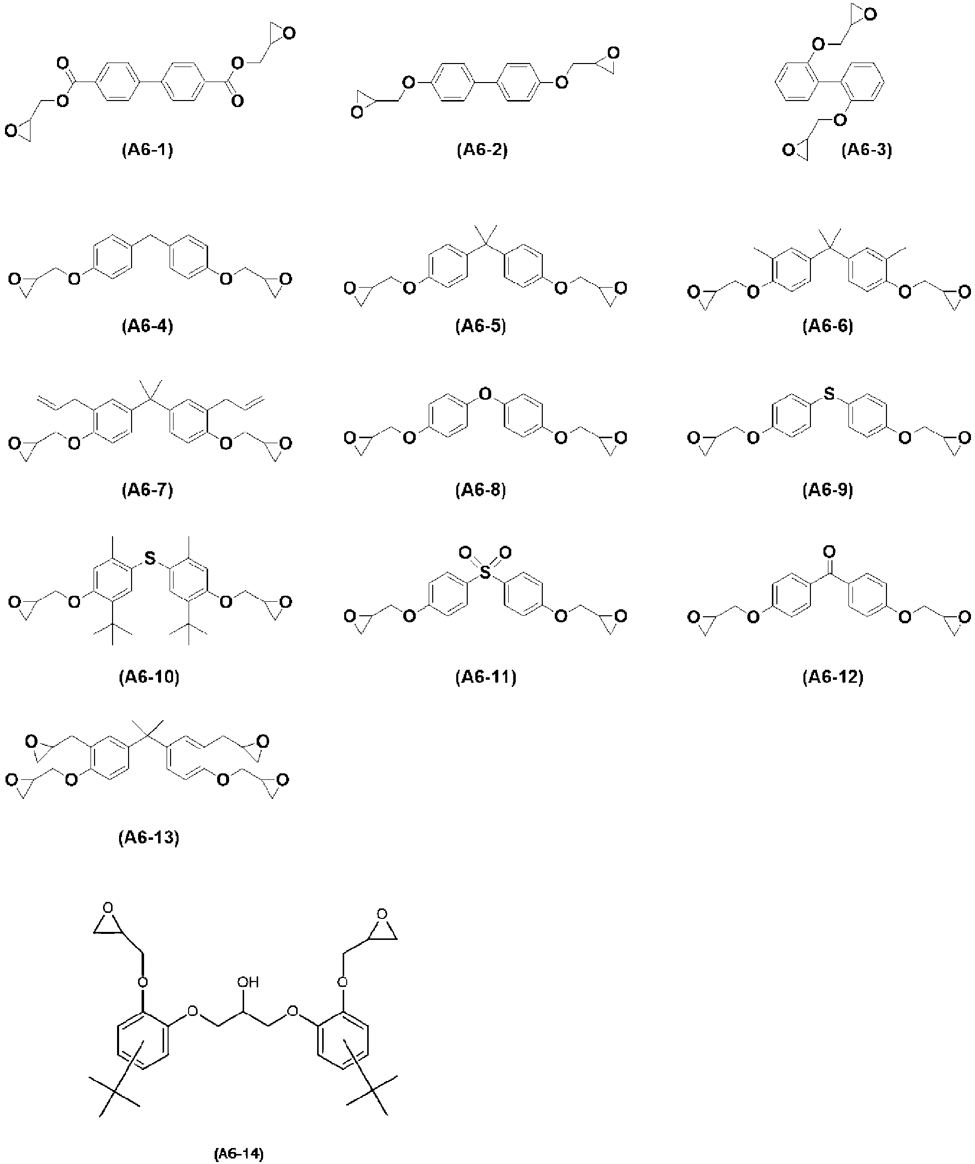

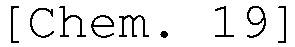

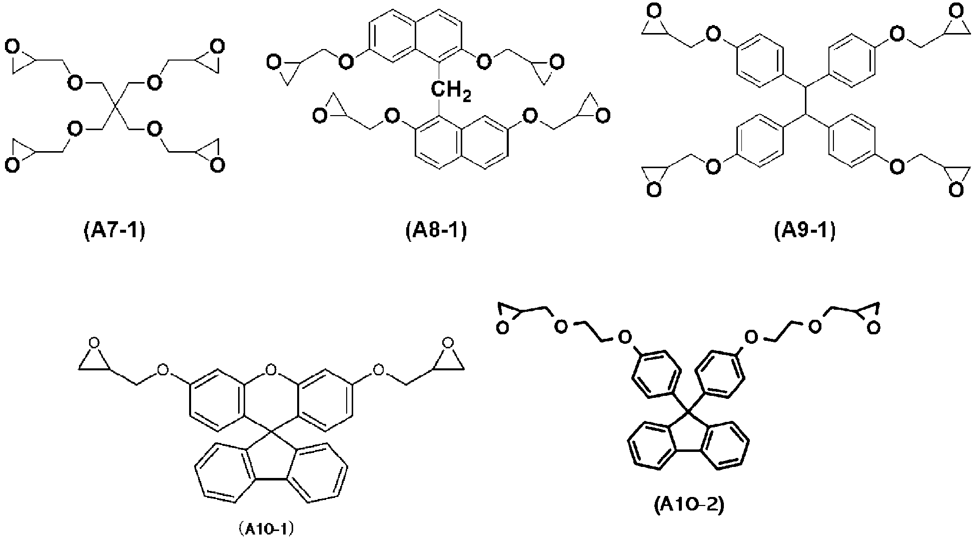

The compound (C) having two or more epoxy groups may be a compound other than the compounds listed above. For example, a compound having an alicyclic structure may be used. Examples of the compound (C) having an alicyclic structure include the following compounds.

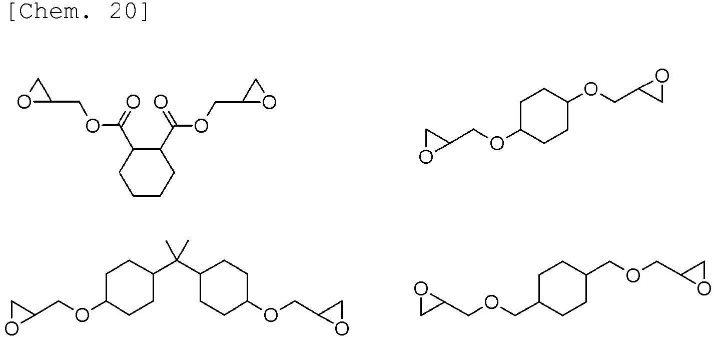

### <<Fluorine-containing Compound Having Group Reactive With Epoxy Group>>

The fluorine-containing compound having two or more groups reactive with an epoxy group is preferably a fluorine-containing compound represented by the following formula (1-A). 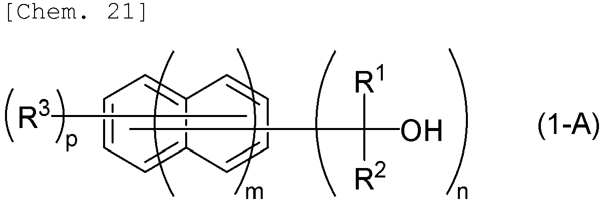 in the formula (1-A), R¹, R², R³, m, n, and p are the same as defined in the formula (1).

Examples of the fluorine-containing compound represented by the formula (1-A) may include, but are not limited to, the following compounds.

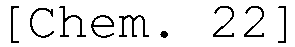

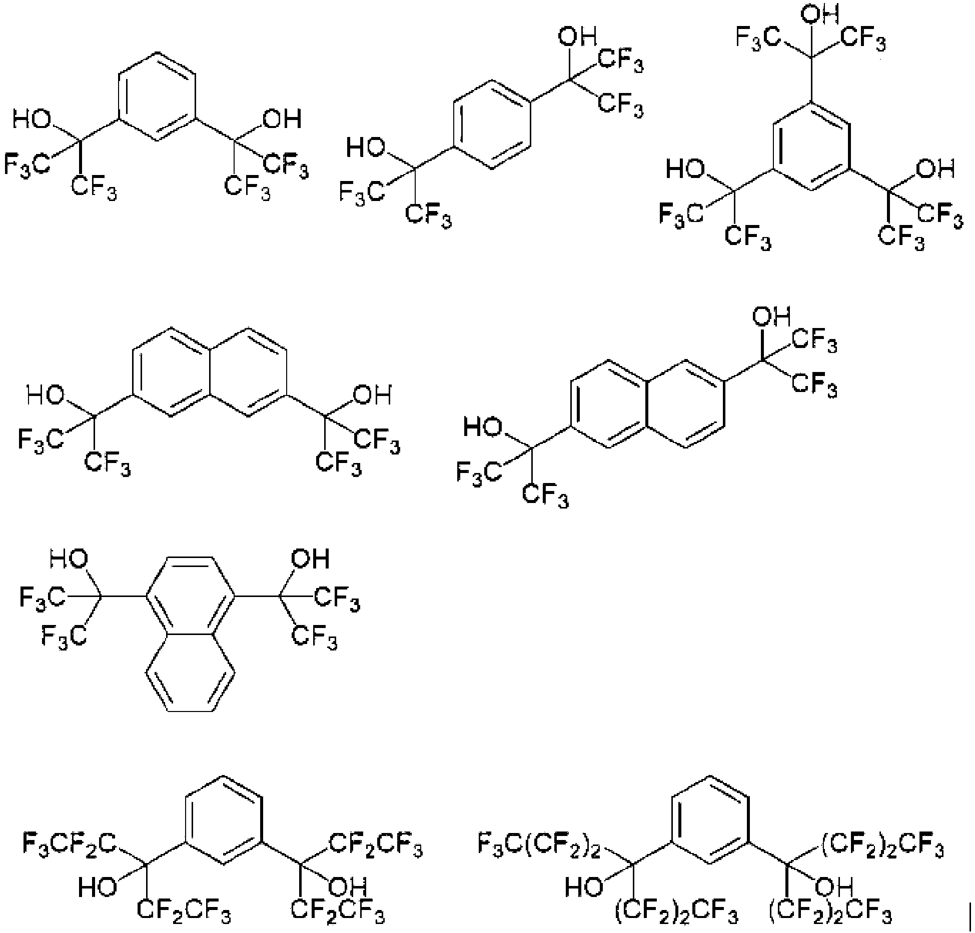

The reaction between the compound having two or more epoxy groups and the compound having two or more groups reactive with the epoxy groups and containing a fluorine atom may be performed, for example, in the presence of a catalyst. Examples of the catalyst include a quaternary phosphonium salt such as tetrabutylphosphonium bromide and ethyltriphenylphosphonium bromide, and a quaternary ammonium salt such as benzyltriethylammonium chloride. The amount of the catalyst to be used can be appropriately selected from a range of 0.1 to 10 mass% relative to the total mass of reaction raw materials to be used in the reaction. The optimum temperature and time for the reaction can be selected from, for example, a range of 80 to 160°C and a range of 2 to 50 hours, respectively.

The molecular weight of the polymer (A) is not particularly limited.

The lower limit of the weight-average molecular weight of the polymer (A) is, for example, 500, 1,000, 2,000, or 3,000.

The upper limit of the weight-average molecular weight of the polymer (A) is, for example, 100,000, 50,000, 30,000, 20,000, or 10,000.

### <Solvent (B)>

The solvent (B) to be contained in the resist underlayer film-forming composition is not particularly limited as long as it can uniformly dissolve a component represented by, e.g., polymer (A), but an organic solvent generally used in a chemical solution for a semiconductor lithography process is preferable. The solvent (B) preferably contains at least one selected from the group consisting of alkylene glycol monoalkyl ethers and monocarboxylic acid esters of alkylene glycol monoalkyl ethers.

Examples of the solvent (B) include ethylene glycol monomethyl ether, ethylene glycol monoethyl ether, methyl cellosolve acetate, ethyl cellosolve acetate, diethylene glycol monomethyl ether, diethylene glycol monoethyl ether, propylene glycol, propylene glycol monomethyl ether, propylene glycol monoethyl ether, propylene glycol monomethyl ether acetate, propylene glycol propyl ether acetate, toluene, xylene, methyl ethyl ketone, methyl isobutyl ketone, cyclopentanone, cyclohexanone, cycloheptanone, 4-methyl-2-pentanol, methyl 2-hydroxyisobutyrate, ethyl 2-hydroxyisobutyrate, ethyl ethoxyacetate, 2-hydroxyethyl acetate, methyl 3-methoxypropionate, ethyl 3-methoxypropionate, ethyl 3-ethoxypropionate, methyl 3-ethoxypropionate, methyl pyruvate, ethyl pyruvate, ethyl acetate, butyl acetate, ethyl lactate, butyl lactate, 2-heptanone, methoxycyclopentane, anisole, γ-butyrolactone, N-methylpyrrolidone, N,N-dimethylformamide, and N,N-dimethylacetamide. These solvents can be used alone, or two or more types of them can be used in combination.

Of these solvents (B), propylene glycol monomethyl ether, propylene glycol monomethyl ether acetate, ethyl lactate, butyl lactate, methyl 2-hydroxyisobutyrate, and cyclohexanone are preferable. In particular, propylene glycol monomethyl ether and propylene glycol monomethyl ether acetate are preferable.

### <Crosslinking Agent (C)>

The resist underlayer film-forming composition preferably further contains a crosslinking agent (C).

The crosslinking agent (C) has a structure different from that of the polymer (A).

The crosslinking agent (C) is preferably an aminoplast crosslinking agent or a phenoplast crosslinking agent.

The aminoplast crosslinking agent is an addition condensate of a compound having an amino group, such as melamine or guanamine, and formaldehyde.

The phenoplast crosslinking agent is an addition condensate of a compound having a phenolic hydroxy group and formaldehyde.

Examples of the crosslinking agent (C) include compounds having two or more structures shown below. 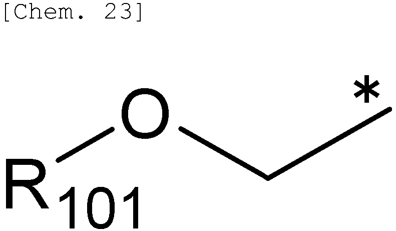 in the structure, R₁₀₁ represents a hydrogen atom, an alkyl group having 1 to 4 carbon atoms, or an alkoxyalkyl group having 2 to 6 carbon atoms; and * represents a bonding arm.

The bonding arm is bound to, for example, a nitrogen atom or a constituent carbon atom of an aromatic hydrocarbon ring.

R₁₀₁ is preferably a hydrogen atom, a methyl group, an ethyl group, or a group represented by the following structure. 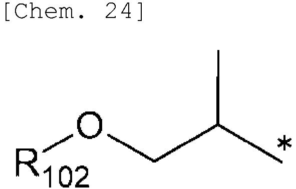 in the structure, R₁₀₂ represents a hydrogen atom, a methyl group, or an ethyl group; and * represents a bonding arm.

The crosslinking agent (C) is preferably a melamine compound, a guanamine compound, a glycoluril compound, a urea compound, or a compound having a phenolic hydroxy group. These can be used alone, or two or more types of them can be used in combination.

Examples of the melamine compound include hexamethylolmelamine, hexamethoxymethylmelamine, a compound in which 1 to 6 methylol groups of hexamethylolmelamine are methoxymethylated or a mixture thereof; hexamethoxyethylmelamine, hexaacyloxymethylmelamine, and a compound in which 1 to 6 methylol groups of hexamethylolmelamine are acyloxymethylated or a mixture thereof.

Examples of the guanamine compound include tetramethylolguanamine, tetramethoxymethylguanamine, a compound in which 1 to 4 methylol groups of tetramethylolguanamine are methoxymethylated or a mixture thereof, tetramethoxyethylguanamine, tetraacyloxyguanamine, and a compound in which 1 to 4 methylol groups of tetramethylolguanamine are acyloxymethylated or a mixture thereof.

Examples of the glycoluril compound include tetramethylolglycoluril, tetramethoxyglycoluril, tetramethoxymethylglycoluril, a compound in which 1 to 4 methylol groups of tetramethylolglycoluril are methoxymethylated or a mixture thereof, and a compound in which 1 to 4 methylol groups of tetramethylolglycoluril are acyloxymethylated or a mixture thereof.

The glycoluril compound may be, for example, a glycoluril derivative represented by the following formula (1E). 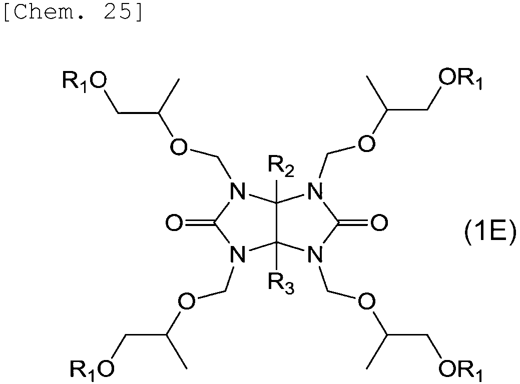 in the formula (1E), four R₁s each independently represent a methyl group or an ethyl group, and R₂ and R₃ each independently represent a hydrogen atom, an alkyl group having 1 to 4 carbon atoms, or a phenyl group.

Examples of the glycoluril derivative represented by the above formula (1E) include compounds represented by the following formula (1E-1) to formula (1E-6).

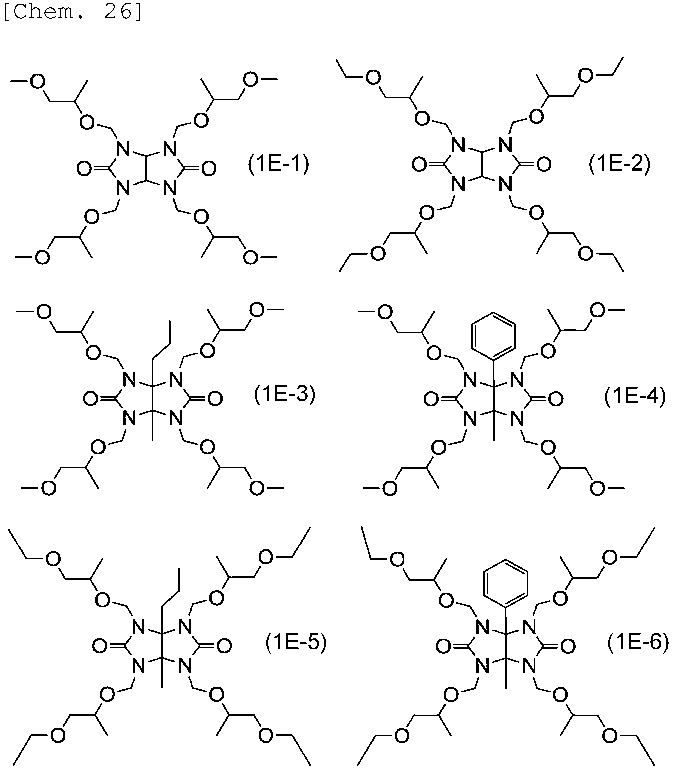

The glycoluril derivative represented by formula (1E) is obtained, for example, by reacting a glycoluril derivative represented by the following formula (2E) with at least one compound represented by the following formula (3d). 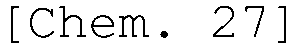 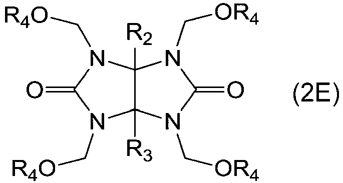 in the formula (2E), R₂ and R₃ each independently represent a hydrogen atom, an alkyl group having 1 to 4 carbon atoms, or a phenyl group, and R₄s each independently represent an alkyl group having 1 to 4 carbon atoms. 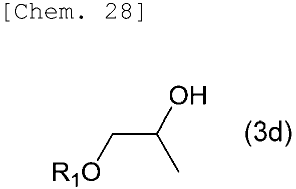 in the formula (3d), R₁ represents a methyl group or an ethyl group.

Examples of the glycoluril derivative represented by formula (2E) include compounds represented by the following formulas (2E-1) to (2E-4). Further, examples of the compound represented by the above formula (3d) include compounds represented by the following formulas (3d-1) and (3d-2).

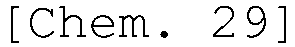

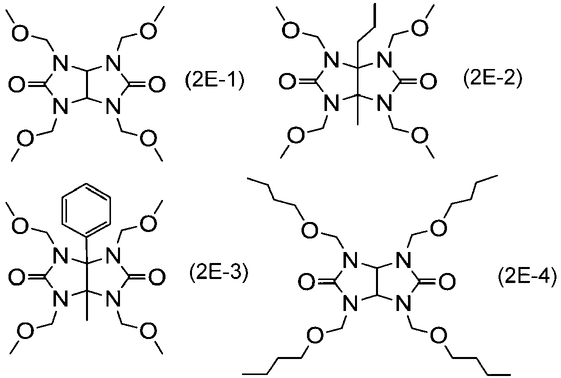

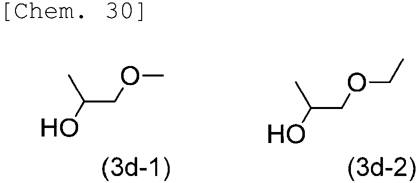

Examples of the urea compound include tetramethylolurea, tetramethoxymethylurea, a tetramethylolurea having 1 to 4 methylol groups methoxymethylated or a mixture thereof, and tetramethoxyethylurea.

Examples of the compound having a phenolic hydroxy group include a compound represented by the following formula (G-1) or (G-2). 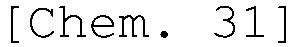 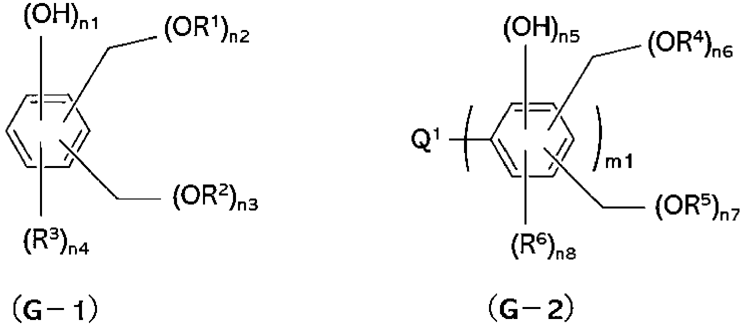
in the formulas (G-1) and (G-2), Q¹ represents a single bond or an m1-valent organic group;
R¹ and R⁴ each represent an alkyl group having 2 to 10 carbon atoms or an alkyl group having 2 to 10 carbon atoms and an alkoxy group having 1 to 10 carbon atoms;
R² and R⁵ each represent a hydrogen atom or a methyl group;
R³ and R⁶ each represent an alkyl group having 1 to 10 carbon atoms or an aryl group having 6 to 40 carbon atoms;
n₁ represents an integer satisfying 1 ≤ n₁ ≤ 3; n₂ represents an integer satisfying 2 ≤ n₂ ≤ 5; n₃ represents an integer satisfying 0 ≤ n₃ ≤ 3; n₄ represents an integer satisfying 0 ≤ n₄ ≤ 3, and 3 ≤ (n₁ + n₂ + n₃ + n₄) ≤ 6;
n₅ represents an integer satisfying 1 ≤ n₅ ≤ 3; n₆ represents an integer satisfying 1 ≤ n₆ ≤ 4; n₇ represents an integer satisfying 0 ≤ n₇ ≤ 3; n₈ represents an integer satisfying 0 ≤ n₈ ≤ 3, and 2 ≤ (n₅ + n₆ + n₇ + n₈) ≤ 5;
and m1 represents an integer of 2 to 10.

Examples of the compound having a phenolic hydroxy group include a compound represented by the following formula (G-3) or (G-4).

The compound represented by the following formula (G-1) or (G-2) may be obtained by a reaction of a compound represented by the following formula (G-3) or (G-4) with a hydroxyl group-containing ether compound or an alcohol having 2 to 10 carbon atoms. 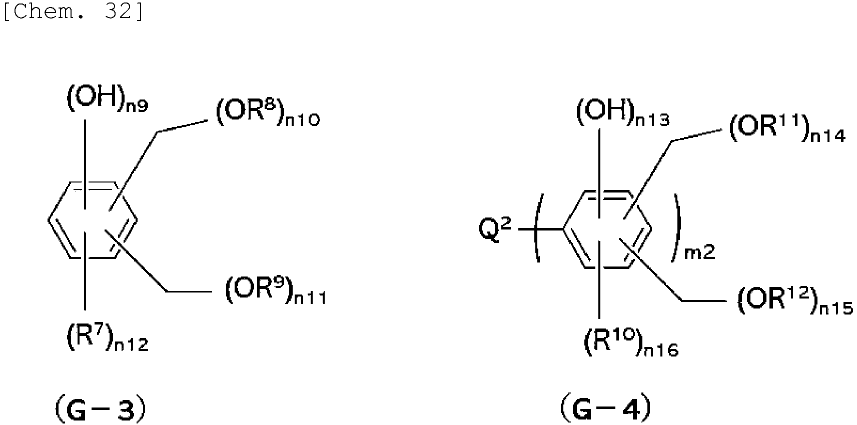
in the formulas (G-3) and (G-4), Q² represents a single bond or an m2-valent organic group;
R⁸, R⁹, R¹¹, and R¹² each represent a hydrogen atom or a methyl group;
R⁷ and R¹⁰ each represent an alkyl group having 1 to 10 carbon atoms or an aryl group having 6 to 40 carbon atoms;
n₉ represents an integer satisfying 1 ≤ n₉ ≤ 3; n₁₀ represents an integer satisfying 2 ≤ n₁₀ ≤ 5; n₁₁ represents an integer satisfying 0 ≤ n₁₁ ≤ 3; n₁₂ represents an integer satisfying 0 ≤ (n₁₂ ≤ 3, and 3 ≤ n₉ + n₁₀ + n₁₁ + n₁₂) ≤ 6;
n₁₃ represents an integer satisfying 1 ≤ n₁₃ ≤ 3; n₁₄ represents an integer satisfying 1 ≤ n₁₄ ≤ 4; n₁₅ represents an integer satisfying 0 ≤ n₁₅ ≤ 3; and n₁₆ represents an integer satisfying 0 ≤ n₁₆ ≤ 3, and an integer satisfying 2 ≤ (n₁₃ + n₁₄ + n₁₅ + n₁₆) ≤ 5;
and m2 represents an integer of 2 to 10.

Examples of the m2-valent organic group in Q² include an m2-valent organic group having 1 to 4 carbon atoms.

Examples of the compound represented by formula (G-1) or formula (G-2) include the following compounds.

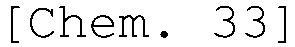

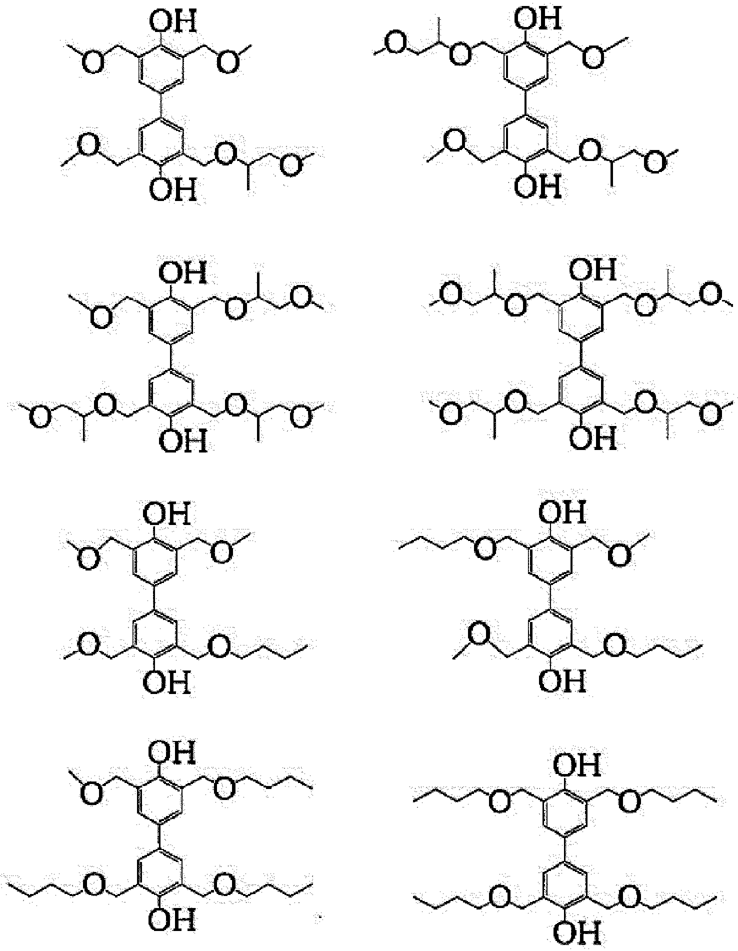

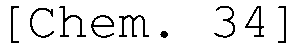

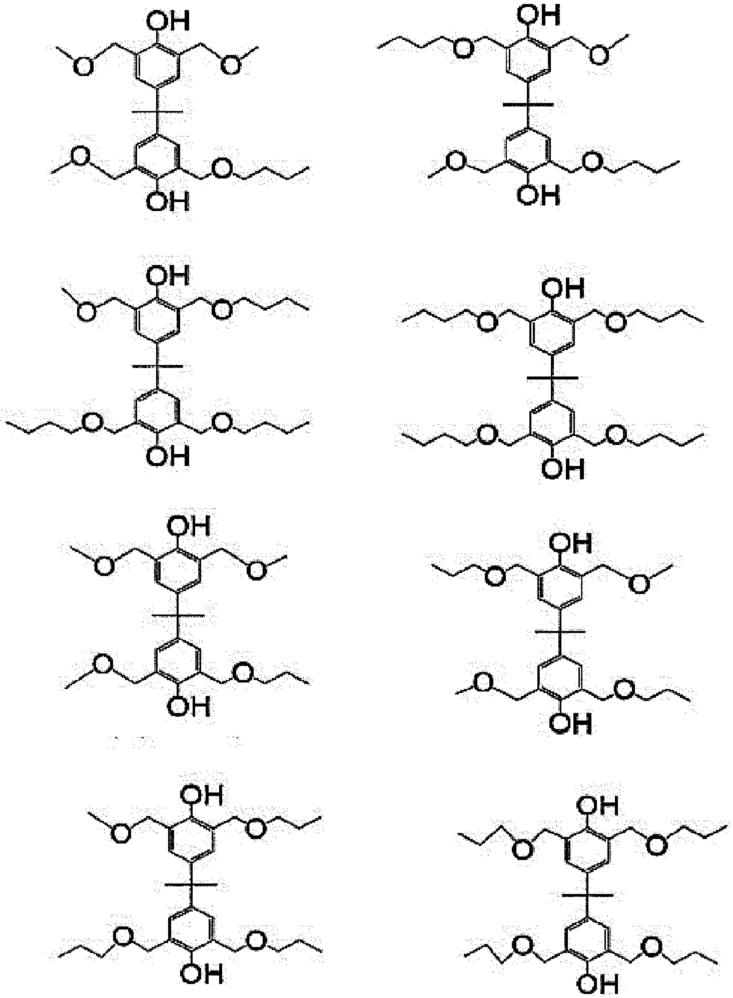

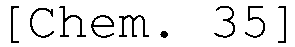

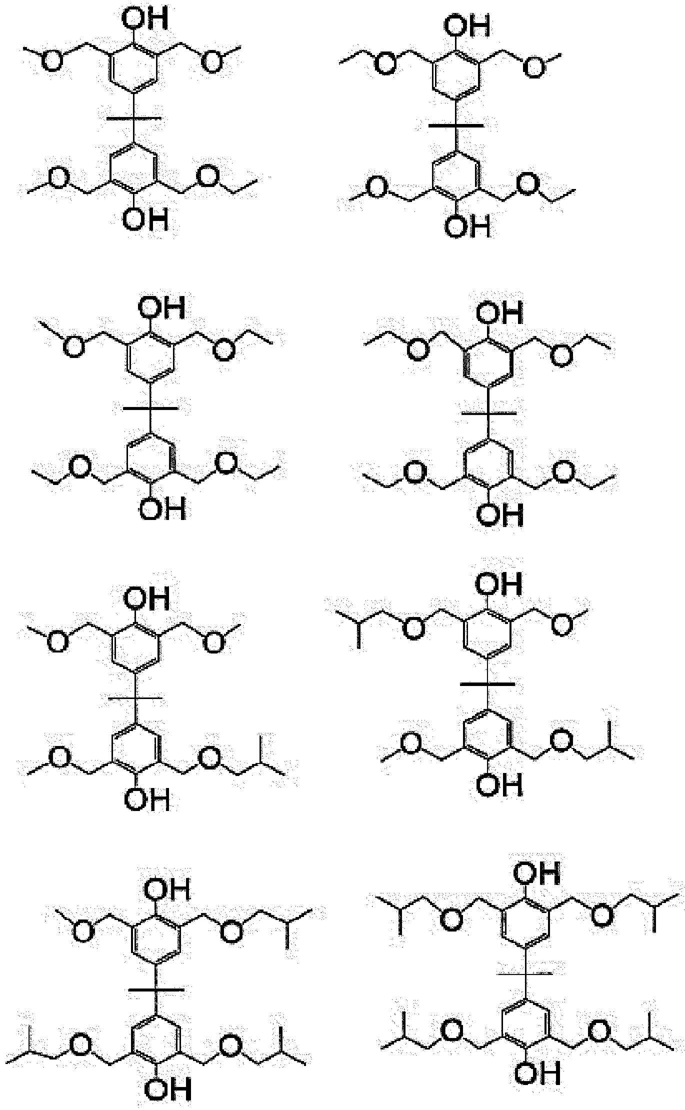

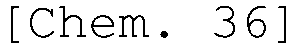

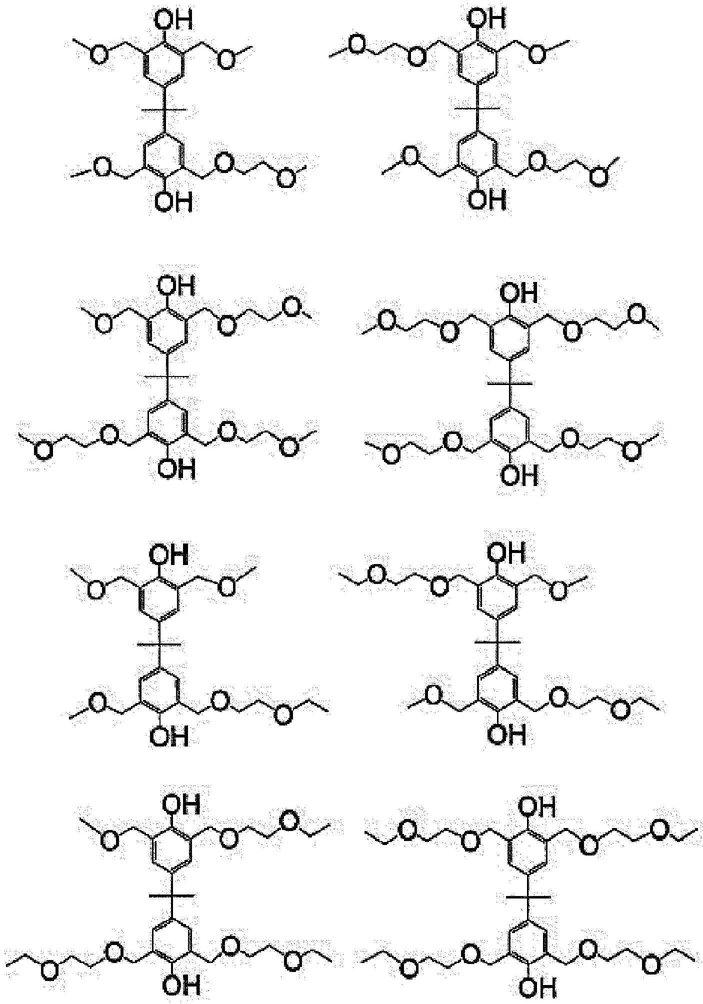

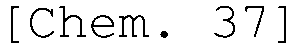

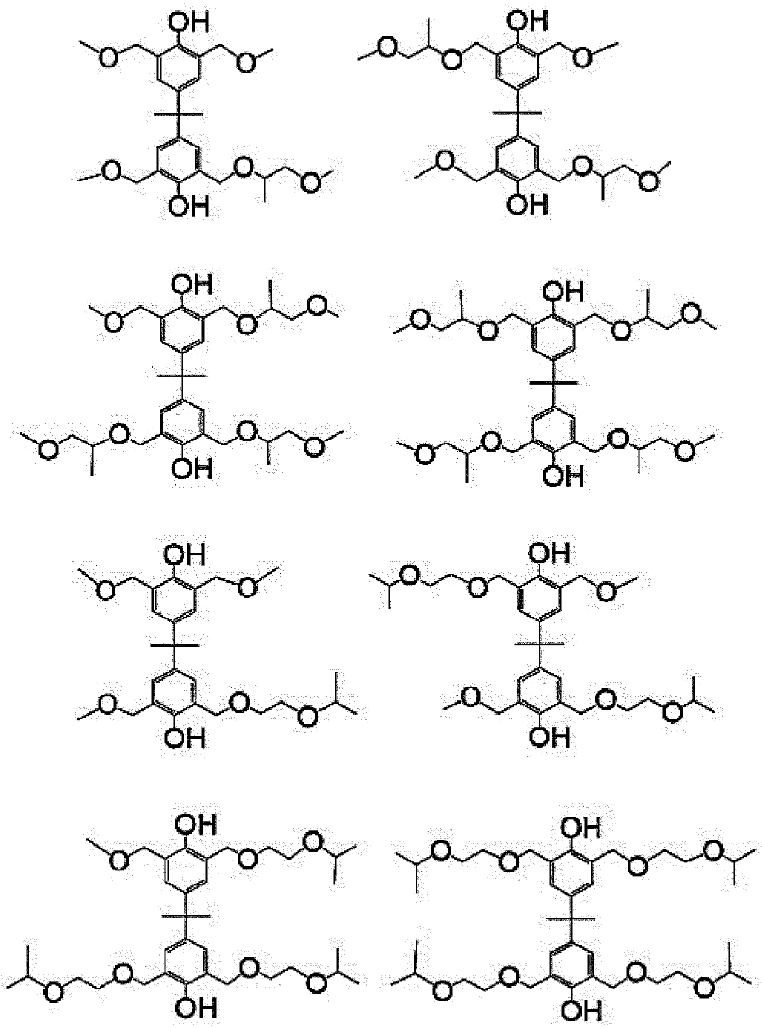

Examples of the compound represented by formula (G-3) or formula (G-4) include the following compounds.

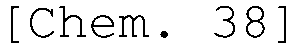

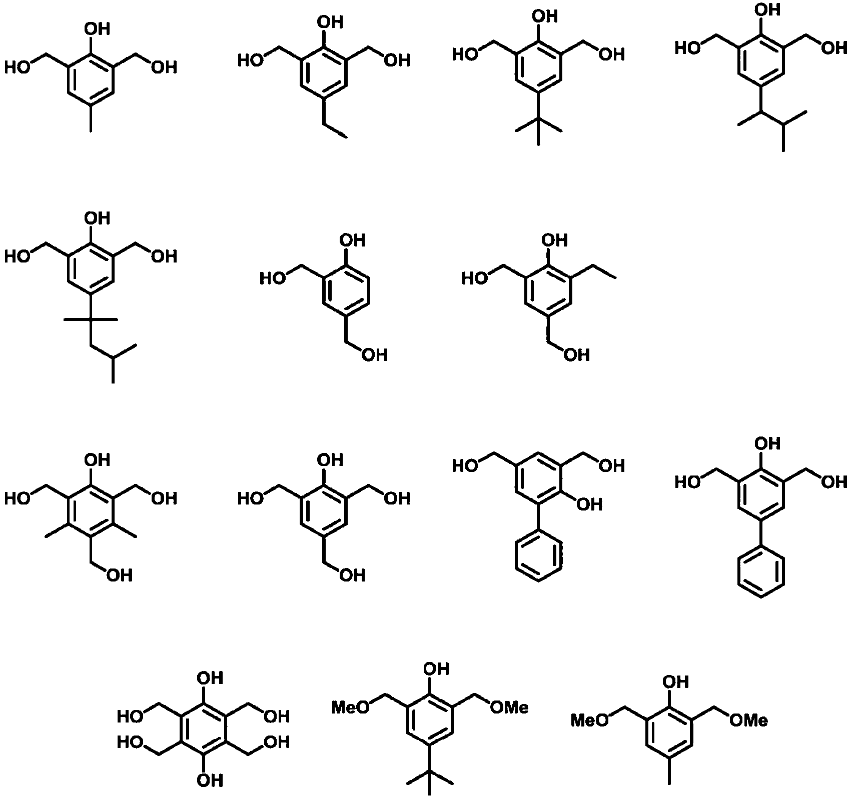

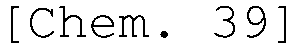

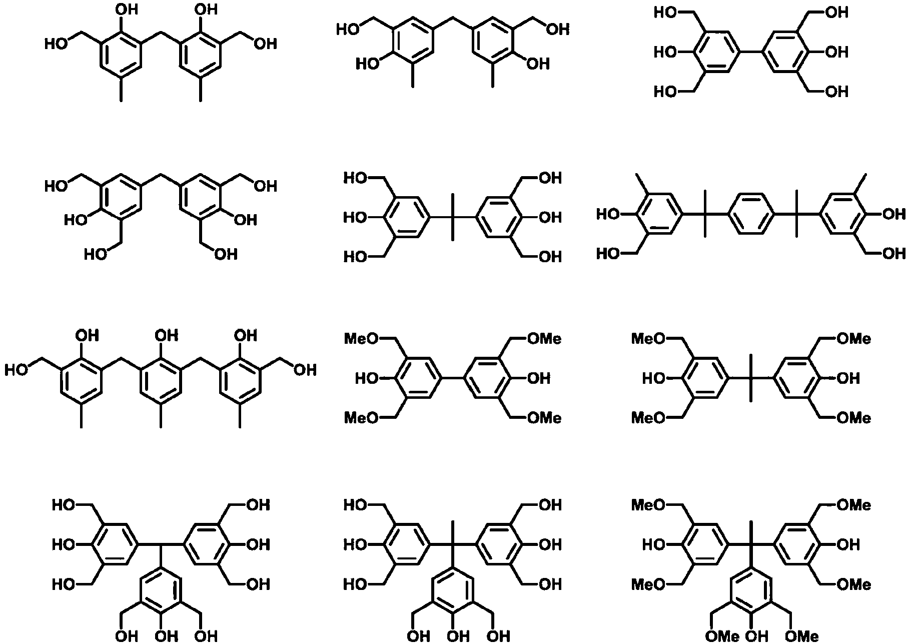

The above compounds can be obtained as products of Asahi Yukizai Corporation and Honshu Chemical Industry Co., Ltd. Examples of the product include TMOM-BP (trade name) manufactured by Asahi Yukizai Corporation.

Of these, a glycoluril compound is preferable. Specifically, tetramethylol glycoluril, tetramethoxy glycoluril, tetramethoxymethyl glycoluril, a compound in which 1 to 4 methylol groups of tetramethylol glycoluril are methoxymethylated or a mixture thereof, and a compound in which 1 to 4 methylol groups of tetramethylol glycoluril are acyloxymethylated or a mixture thereof are preferable and tetramethoxymethyl glycoluril is more preferable.

The molecular weight of the crosslinking agent (C) is not particularly limited, and is preferably 500 or less.

The content of the crosslinking agent (C) in the resist underlayer film-forming composition is not particularly limited, and is, for example, 1 mass% to 70 mass%, and preferably 5 mass% to 60 mass% relative to the polymer (A).

### <Curing catalyst (D)>

The resist underlayer film-forming composition preferably further contains a curing catalyst (D). Examples of the curing catalyst include an acid generator. As the acid generator, either a thermal acid generator or a photoacid generator can be used, but a thermal acid generator is preferably used.

Examples of the thermal acid generator include sulfonic acid compounds such as p-toluenesulfonic acid, trifluoromethanesulfonic acid, pyridinium-p-toluenesulfonate (pyridinium-p-toluenesulfonic acid), pyridinium phenol sulfonic acid, pyridinium-p-hydroxybenzenesulfonic acid (pyridinium p-phenolsulfonic acid salt), pyridinium-trifluoromethanesulfonic acid, salicylic acid, camphorsulfonic acid, 5-sulfosalicylic acid, 4-chlorobenzenesulfonic acid, 4-hydroxybenzenesulfonic acid, benzenedisulfonic acid, 1-naphthalenesulfonic acid, citric acid, benzoic acid, and hydroxybenzoic acid, and carboxylic acid compounds.

Examples of the photoacid generator include an onium salt compound, a sulfonimide compound, and a disulfonyldiazomethane compound.

Examples of the onium salt compounds include iodonium salt compounds such as diphenyliodonium hexafluorophosphate, diphenyliodonium trifluoromethanesulfonate, diphenyliodonium nonafluoronormalbutanesulfonate, diphenyliodonium perfluoronormaloctanesulfonate, diphenyliodonium camphorsulfonate, bis(4-tert-butylphenyl)iodonium camphorsulfonate, and bis(4-tert-butylphenyl)iodonium trifluoromethanesulfonate; and sulfonium salt compounds such as triphenylsulfonium hexafluoroantimonate, triphenylsulfonium nonafluoronormalbutanesulfonate, triphenylsulfonium camphorsulfonate, and triphenylsulfonium trifluoromethanesulfonate.

Examples of the sulfonimide compound include N-(trifluoromethanesulfonyloxy)succinimide, N-(nonafluoronormalbutanesulfonyloxy)succinimide, N-(camphorsulfonyloxy)succinimide, and N-(trifluoromethanesulfonyloxy)naphthalimide.

Examples of the disulfonyldiazomethane compounds include bis(trifluoromethylsulfonyl)diazomethane, bis(cyclohexylsulfonyl)diazomethane, bis(phenylsulfonyl)diazomethane, bis(p-toluenesulfonyl)diazomethane, bis(2,4-dimethylbenzenesulfonyl)diazomethane, and methylsulfonyl-p-toluenesulfonyl diazomethane.

The acid generators can be used alone or two or more types of them can be used in combination.

When an acid generator is used, the content ratio of the acid generator is, for example, 0.1 mass% to 50 mass%, and preferably 1 mass% to 30 mass% relative to the following crosslinking agent.

### <Other Components>

In the resist underlayer film-forming composition, further a surfactant can be added to prevent generation of, e.g., pinholes and striation, and to further improve the coating property to a rough surface.

Further, a polymer other than the polymer (A) can be added. Examples of the polymer include polymers disclosed in WO 2013/018802 A and polymers containing hydroxyarene.

Examples of the surfactant include nonionic surfactants including polyoxyethylene alkyl ethers such as polyoxyethylene lauryl ether, polyoxyethylene stearyl ether, polyoxyethylene cetyl ether, and polyoxyethylene oleyl ether, polyoxyethylene alkyl aryl ethers such as polyoxyethylene octylphenol ether and polyoxyethylene nonylphenol ether, polyoxyethylene and polyoxypropylene block copolymers, sorbitan fatty acid esters such as sorbitan monolaurate, sorbitan monopalmitate, sorbitan monostearate, sorbitan monooleate, sorbitan trioleate, and sorbitan tristearate, and polyoxyethylene sorbitan fatty acid esters such as polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate; fluorine-based surfactants such as EFTOP EF301, EF303, and EF352 (trade name, manufactured by Tochem Products Co., Ltd.), MEGAFAC F171, F173, and R-30 (trade name, manufactured by DIC Corporation), Fluorad FC430 and FC431 (trade name, manufactured by Sumitomo 3M Limited), Asahi Guard AG710, Surflon S-382, SC101, SC102, SC103, SC104, SC105, and SC106 (trade name, manufactured by AGC Corporation); and an organosiloxane polymer KP341 (manufactured by Shin-Etsu Chemical Co., Ltd.).

The blended amount of such a surfactant is usually 2.0 mass% or less, and preferably 1.0 mass% or less relative to the total solid content of the resist underlayer film-forming composition.

These surfactants may be added alone, or two or more types of them can also be added in combination.

The solid content in the resist underlayer film-forming composition of the present invention, that is, the content of the components excluding the solvent is, for example, 0.01 mass% to 10 mass%.

### (Resist Underlayer Film)

The resist underlayer film of the present invention is a cured product of the aforementioned resist underlayer film-forming composition.

The resist underlayer film can be produced, for example, by applying the aforementioned resist underlayer film-forming composition on a semiconductor substrate and baking the composition.

Examples of the semiconductor substrate to which the resist underlayer film-forming composition is to be applied include a silicon wafer, a germanium wafer, and compound semiconductor wafers such as gallium arsenide, indium phosphide, gallium nitride, indium nitride, and aluminum nitride.

When a semiconductor substrate having an inorganic film formed on a surface thereof is used, the inorganic film is formed by, for example, an atomic layer deposition (ALD) method, a chemical vapor deposition (CVD) method, a reactive sputtering method, an ion plating method, a vacuum deposition method, or a spin coating method (spin on glass: SOG). Examples of the inorganic film include a polysilicon film, a silicon oxide film, a silicon nitride film, a boro-phospho silicate glass (BPSG) film, a titanium nitride film, a titanium nitride oxide film, a tungsten film, a gallium nitride film, and a gallium arsenide film.

On such a semiconductor substrate, the resist underlayer film-forming composition of the present invention is applied by an appropriate coating method such as a spinner or a coater. Thereafter, baking is performed by a heating means such as a hot plate to form a resist underlayer film. The baking conditions are appropriately selected from a baking temperature of 100°C to 400°C and a baking time of 0.3 minutes to 60 minutes. Preferably, the baking temperature is 120°C to 350°C and the baking time is 0.5 minutes to 30 minutes, and more preferably, the baking temperature is 150°C to 300°C and the baking time is 0.8 minutes to 10 minutes.

The film thickness of the resist underlayer film is, for example, 0.001 µm (1 nm) to 10 µm, 0.002 µm (2 nm) to 1 µm, 0.005 µm (5 nm) to 0.5 µm (500 nm), 0.001 µm (1 nm) to 0.05 µm (50 nm), 0.002 µm (2 nm) to 0.05 µm (50 nm), 0.003 µm (3 nm) to 0.05 µm (50 nm), 0.004 µm (4 nm) to 0.05 µm (50 nm), 0.005 µm (5 nm) to 0.05 µm (50 nm), 0.003 µm (3 nm) to 0.03 µm (30 nm), 0.003 µm (3 nm) to 0.02 µm (20 nm), 0.005 µm (5 nm) to 0.02 µm (20 nm), 0.003 µm (3 nm) to 0.01 µm (10 nm), 0.005 µm (5 nm) to 0.01 µm (10 nm), 0.003 µm (3 nm) to 0.006 µm (6 nm), or 0.005 µm (5 nm).

The method of measuring the film thickness of the resist underlayer film in the specification is as follows.
· Name of measurement device: Ellipsometric film thickness measurement device RE-3100 (SCREEN Holdings Co., Ltd.)
· Single wavelength ellipsometer (SWE) mode
· Arithmetic average of 8 points (for example, measurement was performed at 8 points at intervals of 1 cm in the wafer X direction)

### (Laminate)

The laminate of the present invention has a semiconductor substrate and the resist underlayer film of the present invention.

Examples of the semiconductor substrate include the semiconductor substrates mentioned above.

The resist underlayer film is disposed on, for example, a semiconductor substrate.

### (Method for Producing Semiconductor Element, and Pattern Forming Method)

The method for producing a semiconductor element of the present invention includes at least the following steps.
· a step of forming a resist underlayer film on a semiconductor substrate using the resist underlayer film-forming composition of the present invention on a semiconductor substrate; and
· a step of forming a resist film on the resist underlayer film.

The pattern forming method of the present invention includes at least the following steps:
· a step of forming a resist underlayer film using the resist underlayer film-forming composition of the present invention on a semiconductor substrate;
· a step of forming a resist film on the resist underlayer film;
· a step of irradiating the resist film with light or an electron beam, and then developing the resist film to obtain a resist pattern; and
· a step of etching a resist underlayer film with the resist pattern used as a mask.

The resist layer is usually formed on the resist underlayer film.

The film thickness of the resist layer is preferably 200 nm or less, more preferably 150 nm or less, still more preferably 100 nm or less, and particularly preferably 80 nm or less. The film thickness of the resist layer is also preferably 10 nm or more, more preferably 20 nm or more, and particularly preferably 30 nm or more.

The resist film to be formed on the resist underlayer film by a known method (such as coating with a resist and baking thereof) is not particularly limited as long as it responds to light or an electron beam (EB) to be used for irradiation. Both a negative photoresist and a positive photoresist can be used.

Note that in the specification, a resist that responds to an EB is also referred to as a photoresist.

Examples of the photoresist include a positive photoresist composed of a novolak resin and 1,2-naphthoquinonediazide sulfonic acid ester; a chemically amplified photoresist composed of a binder having a group, which is decomposed by an acid to increase the alkali dissolution rate, and a photoacid generator; a chemically amplified photoresist composed of a low molecular compound, which is decomposed by an acid to increase the alkali dissolution rate of the photoresist, an alkali-soluble binder, and a photoacid generator; a chemically amplified photoresist composed of a binder having a group, which is decomposed by an acid to increase the alkali dissolution rate, a low molecular compound, which is decomposed by an acid to increase the alkali dissolution rate of the photoresist, and a photoacid generator; and a resist containing a metal element. Examples thereof include V146G (trade name) manufactured by JSR Corporation, APEX-E (trade name) manufactured by Shipley, PAR710 (trade name) manufactured by SUMITOMO CHEMICAL COMPANY, LIMITED, and AR2772 and SEPR430 (trade names) manufactured by Shin-Etsu Chemical Co., Ltd. Further, examples thereof include a fluorine-containing polymer-based photoresist as disclosed in Proc. SPIE, Vol. 3999, 330-334 (2000), Proc. SPIE, Vol. 3999, 357-364 (2000), or Proc. SPIE, Vol. 3999, 365-374 (2000).

So-called resist compositions such as resist compositions, radiation-sensitive resin compositions, high-resolution patterning compositions based on organometallic solutions, and metal-containing resist compositions, which are disclosed in WO2019/188595 A, WO2019/187881 A, WO2019/187803 A, WO2019/167737 A, WO2019/167725 A, WO2019/187445 A, WO2019/167419 A, WO2019/123842 A, WO2019/054282 A, WO2019/058945 A, WO2019/058890 A, WO2019/039290 A, WO2019/044259 A, WO2019/044231 A, WO2019/026549 A, WO2018/193954 A, WO2019/172054 A, WO2019/021975 A, WO2018/230334 A, WO2018/194123 A, JP 2018-180525 A, WO2018/190088 A, JP 2018-070596 A, JP 2018-028090 A, JP 2016-153409 A, JP 2016-130240 A, JP 2016-108325 A, JP 2016-047920 A, JP 2016-035570 A, JP 2016-035567 A, JP 2016-035565 A, JP 2019-101417 A, JP 2019-117373 A, JP 2019-052294 A, JP 2019-008280 A, JP 2019-008279 A, JP 2019-003176 A, JP 2019-003175 A, JP 2018-197853 A, JP 2019-191298 A, JP 2019-061217 A, JP 2018-045152 A, JP 2018-022039 A, JP 2016-090441 A, JP 2015-10878 A, JP 2012-168279 A, JP 2012-022261 A, JP 2012-022258 A, JP 2011-043749 A, JP 2010-181857 A, JP 2010-128369 A, WO2018/031896 A, JP 2019-113855 A, WO2017/156388 A, WO2017/066319 A, JP 2018-41099 A, WO2016/065120 A, WO2015/026482 A, JP 2016-29498 A, and JP 2011-253185 A, can be used, but are not limited to these.

Examples of the resist composition include the following compositions.

An actinic ray-sensitive or radiation-sensitive resin composition containing resin A having a repeating unit having an acid-decomposable group, in which a polar group is protected by a protecting group removable by action of an acid, and a compound represented by the following general formula (121).

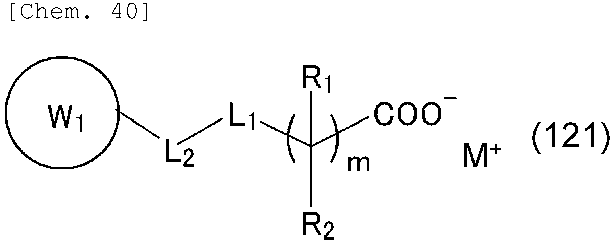

In the general formula (121), m represents an integer of 1 to 6;
R₁ and R₂ each independently represent a fluorine atom or a perfluoroalkyl group;
L₁ represents -O-, -S-, -COO-, -SO₂-, or -SO₃-;
L₂ represents an alkylene group that may have a substituent, or a single bond;
W₁ represents a cyclic organic group that may have a substituent; and
M⁺ represents a cation.

A metal-containing film forming composition for lithography with extreme ultraviolet ray or electron beam, containing a compound having a metal-oxygen covalent bond, and a solvent, in which the metal element, i.e., a composition element, of the above compound belongs to Periods 3 to 7 of Groups 3 to 15 of the periodic table.

A radiation-sensitive resin composition containing a polymer having a first structural unit represented by the following formula (31) and a second structural unit represented by the following formula (32) and containing an acid-dissociable group; and an acid generator. 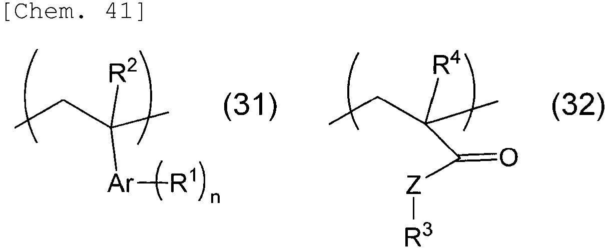 in the formula (31), Ar is a group obtained by removing (n + 1) hydrogen atoms from an arene having 6 to 20 carbon atoms; R¹ is a hydroxy group, a sulfanyl group, or a monovalent organic group having 1 to 20 carbon atoms; n is an integer of 0 to 11, with the proviso that, if n is 2 or more, R¹s are the same or different; R² is a hydrogen atom, a fluorine atom, a methyl group, or a trifluoromethyl group; in formula (32), R³ is a monovalent group having 1 to 20 carbon atoms and containing the acid-dissociable group; Z is a single bond, an oxygen atom, or a sulfur atom; R⁴ is a hydrogen atom, a fluorine atom, a methyl group, or a trifluoromethyl group.

A resist composition containing a resin (A1) containing a structural unit having a cyclic carbonate structure, a structural unit represented by the following formula, and a structural unit having an acid-labile group; and an acid generator. 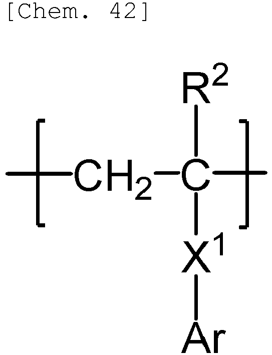
in the formula,
R² represents an alkyl group which has 1 to 6 carbon atoms and may have a halogen atom or represents a hydrogen atom or a halogen atom; X¹ represents a single bond, -CO-O-*, or -CO-NR⁴-*; * represents a bonding arm with -Ar; R⁴ represents a hydrogen atom or an alkyl group having 1 to 4 carbon atoms; and Ar represents an aromatic hydrocarbon group having 6 to 20 carbon atoms, which may have one or more groups selected from the group consisting of hydroxy groups and carboxyl groups.

Examples of the resist film include the following films.

A resist film containing a base resin containing a repeating unit represented by the following formula (a1) and/or a repeating unit represented by the following formula (a2), and a repeating unit that generates an acid bound to a polymer main chain by light exposure. 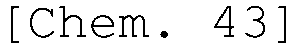 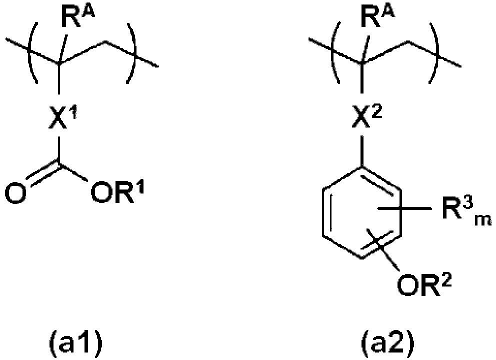 in formulas (a1) and (a2), R^{A}s are each independently a hydrogen atom or a methyl group; R1 and R² are each independently a tertiary alkyl group having 4 to 6 carbon atoms, R3^{s} are each independently a fluorine atom or a methyl group; m is an integer of 0 to 4; X1 is a single bond, a phenylene group, a naphthylene group, or a linking group having 1 to 12 carbon atoms and containing at least one selected from an ester bond, a lactone ring, a phenylene group, and a naphthylene group; and X² is a single bond, an ester bond, or an amide bond.

Examples of the resist material include the following materials.

A resist material containing a polymer having a repeating unit represented by the following formula (b1) or (b2). 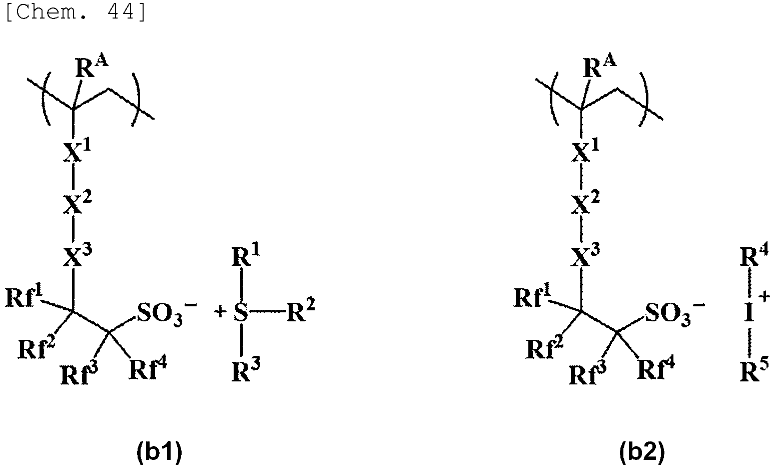 in formulas (b1) and (b2), R^{A} is a hydrogen atom or a methyl group; X1 is a single bond or an ester group; X2 is a linear, branched, or cyclic alkylene group having 1 to 12 carbon atoms or an arylene group having 6 to 10 carbon atoms, in which part of methylene groups constituting the alkylene group may be substituted with an ether group, an ester group, or a lactone ring-containing group, and at least one hydrogen atom contained in X² is substituted with a bromine atom; X3 is a single bond, an ether group, an ester group, or a linear, branched, or cyclic alkylene group having 1 to 12 carbon atoms, in which part of methylene groups constituting the alkylene group may be substituted with an ether group or an ester group; Rf1 to Rf⁴ are each independently a hydrogen atom, a fluorine atom, or a trifluoromethyl group, and at least one of them is a fluorine atom or a trifluoromethyl group; Rf1 and Rf² may be joined to form a carbonyl group; R¹ to R⁵ are each independently a linear, branched, or cyclic alkyl group having 1 to 12 carbon atoms, a linear, branched, or cyclic alkenyl group having 2 to 12 carbon atoms, an alkynyl group having 2 to 12 carbon atoms, an aryl group having 6 to 20 carbon atoms, an aralkyl group having 7 to 12 carbon atoms, or an aryloxyalkyl group having 7 to 12 carbon atoms, in which part or whole of hydrogen atoms of these groups may be substituted with a hydroxy group, a carboxyl group, a halogen atom, an oxo group, a cyano group, an amide group, a nitro group, a sultone group, a sulfone group, or a sulfonium salt-containing group, and part of methylene groups constituting these groups may be substituted with an ether group, an ester group, a carbonyl group, a carbonate group, or a sulfonic acid ester group; and R¹ and R² may bind to form a ring together with the sulfur atom to which these are bound.

A resist material containing a base resin containing a polymer containing a repeating unit represented by the following formula (a). 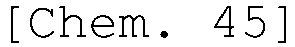 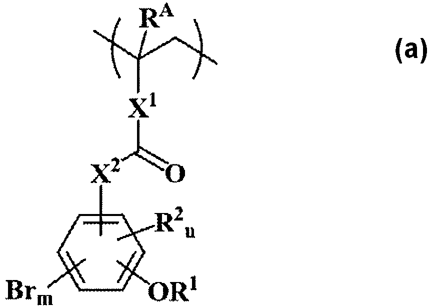 in the formula (a), R^{A} is a hydrogen atom or a methyl group; R¹ is a hydrogen atom or an acid-labile group; R² is a linear, branched, or cyclic alkyl group having 1 to 6 carbon atoms or a halogen atom except bromine; X1 is a single bond, a phenylene group, or a linear, branched, or cyclic alkylene group having 1 to 12 carbon atoms that may contain an ester group or a lactone ring; X2 is -O-, -O-CH₂-, or -NH-; and m is an integer of 1 to 4 and u is an integer of 0 to 3, with the proviso that m + u is an integer of 1 to 4.

A resist composition, which generates an acid by light exposure and the solubility of which in a developer is changed by the action of the acid, containing
a base material component (A) whose solubility in the developer is changed by the action of the acid and a fluorine additive component (F) exhibiting degradability to an alkaline developer, wherein
the fluorine additive component (F) contains a fluororesin component (F1) having a constituent unit (f1) containing a base dissociable group and a constituent unit (f2) containing a group represented by the following general formula (f2-r-1)). 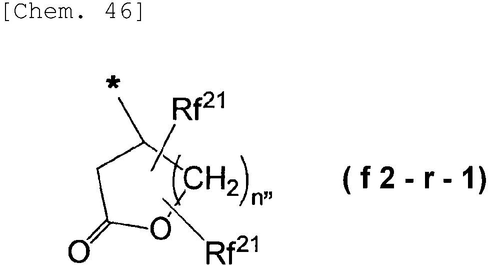
in the formula (f2-r-1), Rf²¹s are each independently a hydrogen atom, an alkyl group, an alkoxy group, a hydroxy group, a hydroxyalkyl group, or a cyano group; n" is an integer of 0 to 2; and * is a bonding arm.

The constituent unit (f1) includes a constituent unit represented by the following general formula (f1-1) or a constituent unit represented by the following general formula (f1-2). 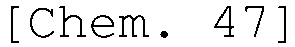 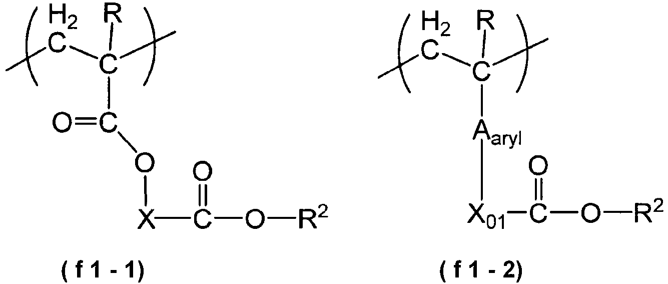 in the formulas (f1-1) and (f1-2), Rs are each independently a hydrogen atom, an alkyl group having 1 to 5 carbon atoms, or a haloalkyl group having 1 to 5 carbon atoms; X is a divalent linking group not having an acid-dissociable site; Aa_{ryl} is a divalent aromatic cyclic group that may have a substituent; X₀₁ is a single bond or a divalent linking group; and R² are each independently an organic group having a fluorine atom.

Examples of the coating, the coating solution, and the coating composition include the following ones.

A coating containing a metal oxo-hydroxo network having an organic ligand via a metal carbon bond and/or a metal carboxylate bond.

A composition of an inorganic oxo/hydroxo-base.

A coating solution containing an organic solvent; a first organometallic composition represented by the formula R_{z}SnO_{(2-(z/2)-(x/2))}(OH)ₓ (wherein 0 < z ≤ 2 and 0 < (z + x) ≤ 4), the formula R'ₙSnX₄₋ₙ (wherein n = 1 or 2), or a mixture thereof, wherein R and R' are independently a hydrocarbyl group having 1 to 31 carbon atoms, and X is a ligand having a hydrolyzable bond to Sn or a combination thereof; and a hydrolyzable metal compound represented by the formula MX'ᵥ (wherein M is a metal selected from groups 2 to 16 in the periodic table of the elements; v is a number of 2 to 6, and X' is a ligand having a hydrolyzable M-X bond or a combination thereof.

A coating solution containing an organic solvent and a first organometallic compound represented by the formula RSnO_{(3/2-x/2)}(OH)ₓ (where 0 < x < 3), in which the solution contains from about 0.0025 M to about 1.5 M of tin; R is an alkyl group or a cycloalkyl group having 3 to 31 carbon atoms, in which the alkyl group or cycloalkyl group is bound to tin at a secondary or tertiary carbon atom.

An aqueous solution of a precursor for forming an inorganic pattern containing a mixture of water, a metal suboxide cation, a polyatomic inorganic anion, and a radiation-sensitive ligand containing a peroxide group.

Irradiation with light or an electron beam is performed, for example, through a mask (reticle) for forming a predetermined pattern. For example, an i-line, a KrF excimer laser, an ArF excimer laser, an extreme ultraviolet ray (EUV), or an electron beam (EB) is used. The resist underlayer film-forming composition of the present invention is preferably applied to the case where an electron beam (EB) or extreme ultraviolet (EUV: 13.5 nm) is applied, and more preferably applied to the case where extreme ultraviolet (EUV) ray is applied.

The irradiation energy of an electron beam and the exposure amount of light are not particularly limited.

Post exposure bake (PEB) may be performed after irradiation with light or an electron beam and before development.

The baking temperature is not particularly limited, and is preferably 60°C to 150°C, more preferably 70°C to 120°C, and particularly preferably 75°C to 110°C.

The baking time is not particularly limited, but is preferably 1 second to 10 minutes, more preferably 10 seconds to 5 minutes, and particularly preferably 30 seconds to 3 minutes.

For the development, for example, an alkaline developer is used.

The developing temperature is, for example, 5°C to 50°C.

The developing time is, for example, 10 seconds to 300 seconds.

Examples of the alkaline developer that can be used include an aqueous solution of an alkali such as an inorganic alkali including, sodium hydroxide, potassium hydroxide, sodium carbonate, sodium silicate, sodium metasilicate, and ammonia water, a primary amine including ethylamine and n-propylamine, a secondary amine including diethylamine and di-n-butylamine, a tertiary amine including triethylamine and methyldiethylamine, an alcoholamine including dimethylethanolamine and triethanolamine, a quaternary ammonium salt including tetramethylammonium hydroxide, tetraethylammonium hydroxide, and choline, and a cyclic amine including pyrrole and piperidine. Further, an alcohol such as isopropyl alcohol, and/or a surfactant such as a nonionic surfactant can be added in an appropriate amount to the aqueous solution of an alkali and put to use. Of these, a preferable developer is an aqueous solution of a quaternary ammonium salt, and a more preferable developer is an aqueous solution of tetramethylammonium hydroxide and an aqueous solution of choline. Further, a surfactant or the like can also be added to these developers. It is also possible to use a method of performing development with an organic solvent such as butyl acetate in place of an alkaline developer to develop a portion of the photoresist where the alkali dissolution rate is not improved.

Subsequently, the resist underlayer film is etched with the formed resist pattern used as a mask. The etching may be dry etching or wet etching, but is preferably dry etching.

If the inorganic film is formed on the surface of a semiconductor substrate used, the surface of the inorganic film is exposed, whereas if the inorganic film is not formed on the surface of a semiconductor substrate used, the surface of the semiconductor substrate is exposed. Thereafter, the semiconductor substrate is subjected to a step of processing a semiconductor substrate by a known method (e.g., dry etching method) to produce a semiconductor element.

### Examples

Hereinafter, the present invention will be described more specifically with reference to Synthesis Examples and Examples, but the present invention is not limited only to the following Examples.

In Examples, devices and conditions used for molecular weight measurement are as follows.

The molecular weight of the polysiloxane used in the present invention is determined by GPC analysis in polystyrene equivalent.

The GPC measurement can be performed in the following conditions: GPC apparatus (trade name: HLC-8220GPC, manufactured by Tosoh Corporation), GPC columns (trade name: Shodex (registered trademark) KF803L, KF802, and KF801, manufactured by Showa Denko K.K.), column temperature of 40°C, eluent (elution solvent): tetrahydrofuran, flow volume (flow rate): 1.0 mL/min, and standard sample: polystyrene (manufactured by Showa Denko K.K.).

### [1] Synthesis of Polymer

### <Synthesis Example 1>

To 18.00 g of propylene glycol monomethyl ether in a reaction vessel, 3.00 g of monoallyl diglycidyl isocyanurate (manufactured by Shikoku Chemicals Corporation), 4.60 g of 1,3-bis(hexafluoro-α-hydroxyisopropyl)benzene (manufactured by Tokyo Chemical Industry Co., Ltd.), and 0.13 g of tetrabutylphosphonium bromide (manufactured by ACROSS) were added and dissolved. After the reaction vessel was purged with nitrogen, a reaction was allowed to proceed at 120°C for 24 hours to obtain a polymer solution. The polymer solution does not become cloudy even if cooled to room temperature, and has good solubility in propylene glycol monomethyl ether. When GPC analysis was performed, the polymer in the obtained solution had a weight average molecular weight of 4,000 in polystyrene equivalent. The polymer obtained in the synthesis example has structural units represented by the following formulas (1a) and (2a).

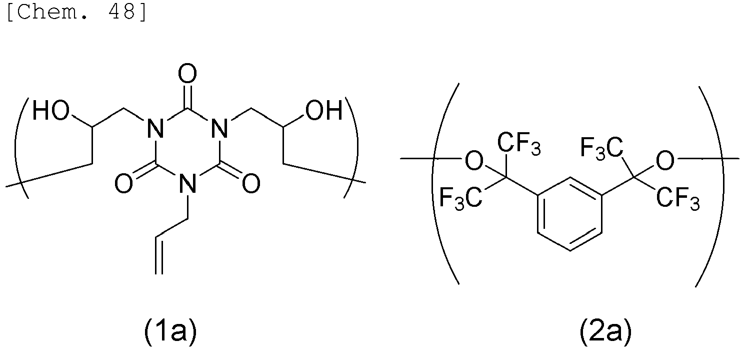

### <Synthesis Example 2>

To 24.20 g of propylene glycol monomethyl ether in a reaction vessel, 4.00 g of 3',6'-bis(2-oxiranylmethoxy)spiro[9H-fluorene-9,9'-[9H]xanthene] (Taoka Chemical Co., Ltd., trade name: TBIS-RXG), 6.20 g of 1,3-bis(hexafluoro-α-hydroxyisopropyl)benzene (manufactured by Tokyo Chemical Industry Co., Ltd.), and 0.17 g of tetrabutylphosphonium bromide (manufactured by ACROSS) were added and dissolved. After the reaction vessel was purged with nitrogen, a reaction was allowed to proceed at 120°C for 24 hours to obtain a polymer solution. The polymer solution does not become cloudy even if cooled to room temperature, and has good solubility in propylene glycol monomethyl ether. When GPC analysis was performed, the polymer in the obtained solution had a weight average molecular weight of 5,000 in polystyrene equivalent. The polymer obtained in the synthesis example has structural units represented by the following formulas (1b) and (2a).

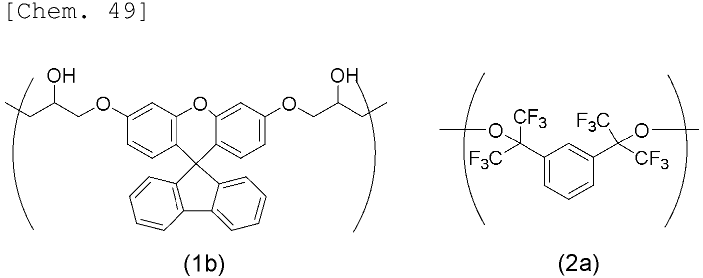

### <Synthesis Example 3>

To 24.92 g of propylene glycol monomethyl ether in a reaction vessel, 7.00 g of monomethyl diglycidyl isocyanurate (manufactured by Shikoku Chemicals Corporation), 3.59 g of 1,3-bis(hexafluoro-α-hydroxyisopropyl)benzene (manufactured by Tokyo Chemical Industry Co., Ltd.), and 0.10 g of tetrabutylphosphonium bromide (manufactured by ACROSS) were added and dissolved. After the reaction vessel was purged with nitrogen, a reaction was allowed to proceed at 120°C for 24 hours to obtain a polymer solution. The polymer solution does not become cloudy even if cooled to room temperature, and has good solubility in propylene glycol monomethyl ether. When GPC analysis was performed, the polymer in the obtained solution had a weight average molecular weight of 4,000 in polystyrene equivalent. The polymer obtained in the synthesis example has structural units represented by the following formulas (1c) and (2a).

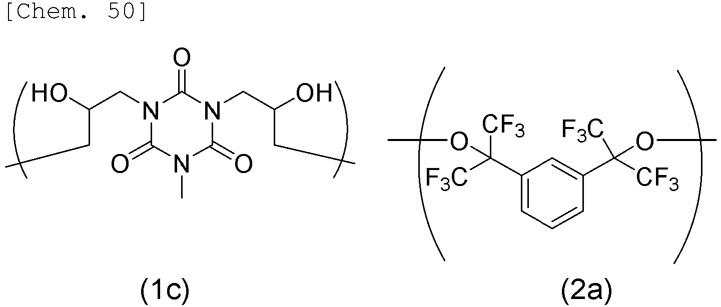

### <Synthesis Example 4>

To 12.56 g of propylene glycol monomethyl ether in a reaction vessel, 4.00 g of a polycondensate of 4-tret-butylbenzene-1,2-diol and 1-chloro-2,3-epoxydipropane (manufactured by DIC Corporation, product name: EPICRON HP-820), 4.25 g of 1,3-bis(hexafluoro-α-hydroxyisopropyl)benzene (manufactured by Tokyo Chemical Industry Co., Ltd.), and 0.12 g of tetrabutylphosphonium bromide (manufactured by ACROSS) were added and dissolved. After the reaction vessel was purged with nitrogen, a reaction was allowed to proceed at 120°C for 24 hours to obtain a polymer solution. The polymer solution does not become cloudy even if cooled to room temperature, and has good solubility in propylene glycol monomethyl ether. When GPC analysis was performed, the polymer in the obtained solution had a weight average molecular weight of 4,000 in polystyrene equivalent. The polymer obtained in the synthesis example has structural units represented by the following formulas (1d) and (2a).

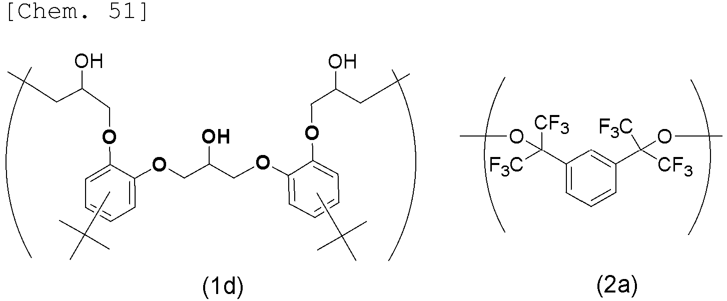

### <Comparative Synthesis Example 1>

To 25.98 g of propylene glycol monomethyl ether in a reaction vessel, 7.00 g of monoallyl diglycidyl isocyanurate (manufactured by Shikoku Chemicals Corporation), 3.84 g of resorcinol (manufactured by Tokyo Chemical Industry Co., Ltd.), and 0.30 g of tetrabutylphosphonium bromide (manufactured by ACROSS) were added and dissolved. After the reaction vessel was purged with nitrogen, a reaction was allowed to proceed at 120°C for 24 hours to obtain a polymer solution. The polymer solution does not become cloudy even if cooled to room temperature, and has good solubility in propylene glycol monomethyl ether. When GPC analysis was performed, the polymer in the obtained solution had a weight average molecular weight of 6000 in polystyrene equivalent. The polymer obtained in the Synthesis Example has structural units represented by the following formulas (1a) and (2b).

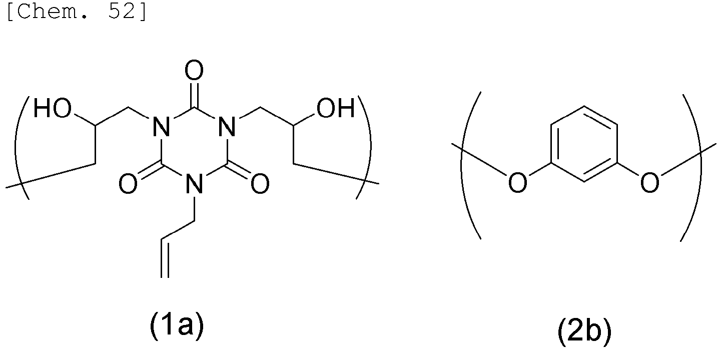

### <Comparative Synthesis Example 2>

To 40.75 g of propylene glycol monomethyl ether in a reaction vessel, 10.00 g of monoallyl diglycidyl isocyanurate (manufactured by Shikoku Chemicals Corporation), 16.74 g of 2,2,2-bis-4-carbohydroxyphenylhexafluoropropane (manufactured by Tokyo Chemical Industry Co., Ltd.), and 0.42 g of tetrabutylphosphonium bromide (manufactured by ACROSS) were added and dissolved. After the reaction vessel was purged with nitrogen, a reaction was allowed to proceed at 120°C for 24 hours to obtain a polymer solution. The polymer solution does not become cloudy even if cooled to room temperature, and has good solubility in propylene glycol monomethyl ether. When GPC analysis was performed, the polymer in the obtained solution had a weight average molecular weight of 5,000 in polystyrene equivalent. The polymer obtained in the synthesis example has structural units represented by the following formulas (1a) and (2c).

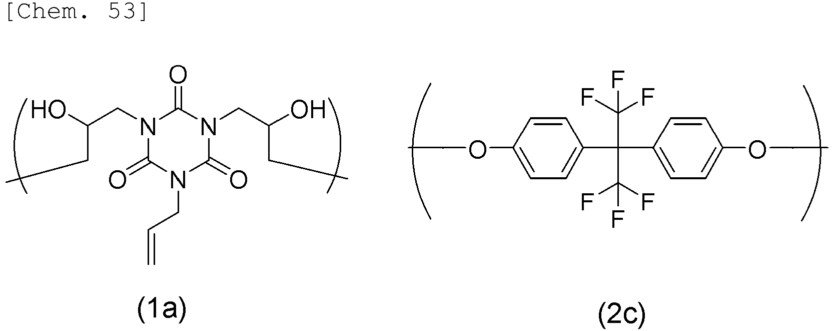

The fluorine atoms contained in individual polymers are shown in the following table.

**[Table 1]**

| Example | Content of fluorine atoms in polymer (mol%) |
|---|---|
| Example 1 | 17.9 |
| Example 2 | 13 |
| Example 3 | 19.1 |
| Example 4 | 12 |
| Comparative Example 1 | 0 |
| Comparative Example 2 | 8.8 |

### [2] Preparation of Resist Underlayer Film-Forming Composition

### (Examples and Comparative Examples)

The polymers obtained in Synthesis Examples 1 to 4, Comparative Synthesis Example 1, and Comparative Synthesis Example 2, and commercially available polymers, a crosslinking agent, a curing catalyst, and a solvent were mixed in the ratios shown in Table 2. The mixtures were filtered by a fluororesin filter of 0.1 µm to prepare solutions of resist underlayer film-forming compositions, respectively.

Abbreviations in Table 1 are shown below.
PL-LI: tetramethoxymethylglycoluril
Py-PSA: pyridinium-p-hydroxybenzenesulfonate
PGME: propylene glycol monomethyl ether
PGMEA: propylene glycol monomethyl ether acetate

Each addition amount was expressed in parts by mass, and the solvent was expressed in composition ratio.

**[Table 2]**

| | | Polymer | Crosslinking agent | Curing catalyst | Solvent | |
|---|---|---|---|---|---|---|
| Example 1 | Composition | Synthesis Example 1 | PL-LI | Py-PSA | PGME | PGMEA |
| | (parts by mass) | 0.157 | 0.039 | 0.004 | 89.82 | 9.98 |
| Example 2 | Composition | Synthesis Example 2 | PL-LI | Py-PSA | PGME | PGMEA |
| | (parts by mass) | 0.157 | 0.039 | 0.004 | 89.82 | 9.98 |
| Example 3 | Composition | Synthesis Example 3 | PL-LI | Py-PSA | PGME | PGMEA |
| | (parts by mass) | 0.157 | 0.039 | 0.004 | 89.82 | 9.98 |
| Example 4 | Composition | Synthesis Example 4 | PL-LI | Py-PSA | PGME | PGMEA |
| | (parts by mass) | 0.157 | 0.039 | 0.004 | 89.82 | 9.98 |
| Comparative Example 1 | Composition | Comparative Synthesis Example 1 | PL-LI | Py-PSA | PGME | PGMEA |
| | (parts by mass) | 0.157 | 0.039 | 0.004 | 89.82 | 9.98 |
| Comparative Example 2 | Composition | Comparative Synthesis Example 1 | PL-LI | Py-PSA | PGME | PGMEA |
| | (parts by mass) | 0.157 | 0.039 | 0.004 | 89.82 | 9.98 |

### [3] Elution Test into Photoresist Solvent

Each of the resist underlayer film-forming compositions of Example 1, Example 2, Example 3, Example 4, Comparative Example 1, and Comparative Example 2 was applied onto a silicon wafer as a semiconductor substrate by a spinner. The silicon wafer was placed on a hot plate and baked at 205°C for 1 minute to form a resist underlayer film (film thickness: 5 nm). These resist underlayer films were each immersed at room temperature for 1 minute in a mixed solvent of propylene glycol monomethyl ether (70 vol%) and propylene glycol monomethyl ether acetate (30 vol%) used as a solvent of a photoresist-forming composition, and then heated at 100°C for 30 seconds to remove the solvent. Thereafter, the film thickness was measured. The results of the solvent resistance test are below. When the reduction rate of the film thickness before and after the dissolution test (film thickness nm reduced before and after the test/film thickness of resist underlayer film nm × 100) was 2% or less (1Å), it was expressed as "good", and when the reduction rate of the film thickness was beyond 2%, it was expressed as "poor" (Table 3).

**[Table 3]**

| Example | Solvent Resistance Test |
|---|---|
| Example 1 | Good |
| Example 2 | Good |
| Example 3 | Good |
| Example 4 | Good |
| Comparative Example 1 | Good |
| Comparative Example 2 | Good |

### [4] Contact Angle Measurement

Each of the resist underlayer film-forming compositions of Example 1, Example 2, Example 3, Example 4, Comparative Example 1, and Comparative Example 2 was applied onto a silicon wafer as a semiconductor substrate by a spinner. The silicon wafer was placed on a hot plate and baked at 205°C for 1 minute to form a resist underlayer film (film thickness: 5 nm). Thereafter, the contact angle with pure water was measured by a contact angle meter (DM701) manufactured by Kyowa Interface Science Co., Ltd. Note that the amount of pure-water droplets was set to 3.0 µl. Measurement was performed at 5 points 3 seconds after the dropping, at 5 points 5 seconds after the dropping, and at 5 points 7 seconds after the dropping, and the average of the measurement values at 15 points in total was taken as the contact angle (Table 4).

**[Table 4]**

| Example | Contact angle (°) with pure water |
|---|---|
| Example 1 | 81 |
| Example 2 | 84 |
| Example 3 | 80 |
| Example 4 | 95 |
| Comparative Example 1 | 53 |
| Comparative Example 2 | 66 |

The underlayer films formed of the resist underlayer film-forming compositions of Examples 1 to 4 all had a contact angle with pure water of 80° or more. In contrast, the underlayer films formed of the resist underlayer film-forming compositions of Comparative Examples 1 and 2 had a contact angle with pure water of less than 80°.

### [5] Formation of Positive Resist Pattern by Electron Beam Lithography Apparatus

Each of the resist underlayer film-forming compositions of Example 1, Example 2 and Comparative Example 1 was applied onto a silicon wafer by a spinner. The silicon wafer was baked on a hot plate at 205°C for 60 seconds to obtain a resist underlayer film having a film thickness of 5 nm. An EUV positive-type resist solution (containing a methacrylic polymer) was spin-coated on the resist underlayer film, and heated at 130°C for 60 seconds to form an EUV resist film. The resist film was exposed under predetermined conditions using an electron beam lithography apparatus (ELS-G130). After light exposure, the film was baked (PEB) at 90°C for 60 seconds, cooled on a cooling plate to room temperature, and developed with an alkaline developer (2.38%TMAH), and then a line-and-space resist pattern having a CD of 25 nm and a pitch of 50 nm was formed. For measuring the length of the resist pattern, a scanning electron microscope (CG4100 manufactured by Hitachi High-Technologies Corporation) was used. In the formation of the resist pattern, the exposure amount necessary for obtaining a pattern having a CD size of 25 nm is shown. It is indicated that the lower the number, the smaller the exposure amount to obtain a desired pattern (Table 5).

**[Table 5]**

| | Exposure amount required to obtain a pattern having CD size of 25 nm |
|---|---|
| Example 1 | 553 uC |
| Example 2 | 548 uC |
| Comparative Example 1 | 588 uC |
| Comparative Example 2 | 566 uC |

When Example 1 and Example 2 were compared with Comparative Example 1 and Comparative Example 2, it was found that in Example 1 and Example 2, the exposure amount required for obtaining a pattern having a CD of 25 nm is low, and the sensitivity is improved.

In addition, the minimum sizes at which the patterns in Example 1 and Comparative Example 2 can be resolved are shown below.

**[Table 6]**

| | Minimum pattern size at which pattern can be resolved |
|---|---|
| Example 1 | 24.2 nm |
| Comparative Example 2 | 24.5 nm |

When Example 1 is compared with Comparative Example 2, it was confirmed that Example 1 can provide the formation of a finer pattern. It is suggested that adhesion is improved because the affinity for the resist is improved by hydrophobization due to an increase in the amount of introduced fluorine atoms.

## Claims

1. A resist underlayer film-forming composition for forming a resist underlayer film comprising:
a polymer (A) and a solvent (B), wherein
the resist underlayer film has a contact angle with water of 80° or more.

2. The resist underlayer film-forming composition according to claim 1, wherein the polymer (A) is a polymer containing fluorine atoms.

3. The resist underlayer film-forming composition according to claim 2, wherein the polymer (A) is a polymer containing 10 mol% or more of the fluorine atoms.

4. A resist underlayer film-forming composition comprising a polymer (A) and a solvent (B), wherein the polymer (A) is a polymer containing 10 mol% or more of fluorine atoms.

5. The resist underlayer film-forming composition according to claim 2 or 4, wherein the polymer (A) is a polymer having a structural unit represented by the following formula (1): 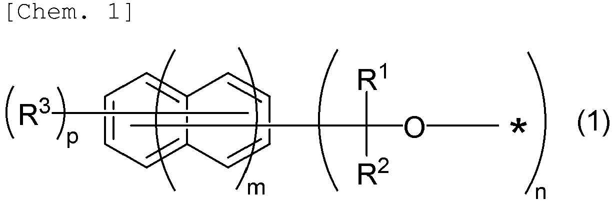 wherein R¹ and R² each independently represent a perfluoroalkyl group having 1 to 6 carbon atoms or a perfluoroalkyl group having 1 to 6 carbon atoms in which 1 to 12 fluorine atoms are substituted with one or both of hydrogen atoms and halogen atoms; R³s each independently represent an alkyl group having 1 to 3 carbon atoms, which may be substituted, or a halogen atom; m represents 0 or 1; n represents 2 or 3; p represents 0 to 6, with the proviso that if m = 0, p + n is 6 or less, and if m = 1, p + n is 8 or less; and * represents a bonding arm.

6. The resist underlayer film-forming composition according to any one of claims 2 to 4, wherein the polymer (A) is a reaction product of a compound having two or more epoxy groups and a fluorine-containing compound having two or more groups reactive with the epoxy groups.

7. The resist underlayer film-forming composition according to any one of claims 1 to 4, wherein the solvent (B) contains at least one selected from the group consisting of alkylene glycol monoalkyl ethers and monocarboxylic acid esters of alkylene glycol monoalkyl ethers.

8. The resist underlayer film-forming composition according to any one of claims 1 to 4, further comprising a crosslinking agent (C).

9. The resist underlayer film-forming composition according to claim 8, wherein the crosslinking agent (C) is at least one selected from the group consisting of aminoplast crosslinking agents and phenoplast crosslinking agents.

10. The resist underlayer film-forming composition according to any one of claims 1 to 4, further comprising a curing catalyst (D).

11. The resist underlayer film-forming composition according to any one of claims 1 to 4, which is used in an extreme ultraviolet (EUV) exposure process.

12. A resist underlayer film, which is a cured product of the resist underlayer film-forming composition according to any one of claims 1 to 4.

13. A laminate, comprising:
a semiconductor substrate; and
the resist underlayer film according to claim 12.

14. A method for producing a semiconductor element, comprising steps of:
forming a resist underlayer film on a semiconductor substrate using the resist underlayer film-forming composition according to any one of claims 1 to 4; and
forming a resist film on the resist underlayer film.

15. A method for forming a pattern, comprising steps of:
forming a resist underlayer film on a semiconductor substrate using the resist underlayer film-forming composition according to any one of claims 1 to 4;
forming a resist film on the resist underlayer film;
irradiating the resist film with light or an electron beam, and then developing the resist film to obtain a resist pattern; and
etching the resist underlayer film with the resist pattern used as a mask.
